(19) **Europäisches Patentamt / European Patent Office / Office européen des brevets**

(11) **EP 1 984 789 B1**

(12) **EUROPÄISCHE PATENTSCHRIFT**

(45) Veröffentlichungstag und Bekanntmachung des Hinweises auf die Patenterteilung:
**06.11.2013 Patentblatt 2013/45**

(21) Anmeldenummer: **07722838.5**

(22) Anmeldetag: **16.02.2007**

(51) Int Cl.:
**G03F 7/20** (2006.01)

(86) Internationale Anmeldenummer:
**PCT/EP2007/001362**

(87) Internationale Veröffentlichungsnummer:
**WO 2007/093433 (23.08.2007 Gazette 2007/34)**

(54) **BELEUCHTUNGSSYSTEM FÜR DIE MIKRO-LITHOGRAPHIE, PROJEKTIONSBELICHTUNGSANLAGE MIT EINEM DERARTIGEN BELEUCHTUNGSSYSTEM**

ILLUMINATION SYSTEM FOR MICROLITHOGRAPHIC PROJECTION EXPOSURE APPARATUS COMPRISING AN ILLUMINATION SYSTEM OF THIS TYPE

SYSTEME D'ECLAIRAGE POUR LA MICRO-LITHOGRAPHIE, EQUIPEMENT D'ECLAIRAGE PAR PROJECTION EQUIPE D'UN TEL SYSTEME D'ECLAIRAGE

(84) Benannte Vertragsstaaten:
**DE FR NL**

(30) Priorität:
**17.02.2006 US 774850 P**
**23.08.2006 US 823296 P**
**09.09.2006 DE 102006042452**
**28.12.2006 DE 102006061711**

(43) Veröffentlichungstag der Anmeldung:
**29.10.2008 Patentblatt 2008/44**

(73) Patentinhaber: **Carl Zeiss SMT GmbH**
**73447 Oberkochen (DE)**

(72) Erfinder:
- **DEGÜNTHER, Markus**
**73432 Aalen (DE)**
- **LAYH, Michael**
**73432 Aalen (DE)**

- **GERHARD, Michael**
**73432 Aalen (DE)**
- **THOME, Bruno**
**73433 Aalen (DE)**
- **SINGER, Wolfgang**
**73431 Aalen (DE)**

(74) Vertreter: **Hofmann, Matthias et al**
**Rau, Schneck & Hübner**
**Patentanwälte**
**Königstrasse 2**
**90402 Nürnberg (DE)**

(56) Entgegenhaltungen:
**EP-A- 1 367 442        WO-A-03/029875**
**US-A1- 2001 052 969        US-A1- 2002 136 351**
**US-A1- 2005 237 623**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Beleuchtungssystem für die Mikro-Lithographie zur Beleuchtung eines Beleuchtungsfeldes mit Beleuchtungslicht. Ferner betrifft die Erfindung eine Mikrolithographie-Projektionsbelichtungsanlage mit einem derartigen Beleuchtungssystem. Weiterhin betrifft die Erfindung ein mikrolithographisches Herstellungsverfahren für mikrostrukturierte Bauelemente. Schließlich betrifft die Erfindung ein mit einem solchen Verfahren hergestelltes Bauelement.

Die EP 1367 442 A2 zeigt ein Beleuchtungssystem, das zur Beleuchtung eines Beleuchtungsfeldes in einer Maskenebene mit Beleuchtungslicht dient. Teil des Beleuchtungssystems ist ein Rastermodul mit zwei Rasteranordnungen (Fly's Eye Members). Das Rastermodul dient zur Erzeugung sekundärerer Lichtquellen. Eine Übertragsoptik dient zur Übertragung des Beleuchtungslichts vom Rastermodul in das Beleuchtungsfeld. Korrekturfilter 15, 16 dienen zur Korrektur von Ungleichmäßigkeiten der Beleuchtung (Uneveness in Illumination).

In der WO 03/029875 A2 ist eine Mikroskopbeleuchtung erläutert, bei der ein Mikrolinsen-Array zum Einsatz kommt. In einer Ebene, die zu dem Mikrolinsen-Array konjugiert ist, ist zur Kohärenzreduktion ein Stufenspiegel angeordnet, der eine Phase des Beleuchtungslichts für verschiedene Rasterelemente des Mikrolinsen-Arrays unterschiedlich beeinflusst.

Die US 2002/0136351 A1 zeigt ein Beleuchtungssystem mit zwei Rasteranordnungen, wobei Rasterelemente dieser Rasteranordnungen einerseits einen brechenden und andererseits einen prismatischen Effekt haben, was figürlich schematisch angedeutet ist.

Ein weiteres Beleuchtungssystem ist bekannt aus der WO 2005/083512 A2. Für anspruchsvolle Projektionsaufgaben ist es wünschenswert, die Beleuchtungslichteigenschaften über das Beleuchtungsfeld gezielt beeinflussen zu können. Dies ist mit dem gattungsgemäßen Beleuchtungssystem nicht bzw. nur mit hohem Aufwand möglich.

Aus der US 2004/0119961 A1 ist ein Beleuchtungssystem für die Mikro-Lithografie bekannt, bei dem Feldrasterelemente und Pupillenrasterelemente mit zusätzlicher prismatischer Wirkung ausgeführt sind, damit ein Übersprechen zwischen Rasterkanälen des Beleuchtungssystems vermieden ist.

Aus der WO 2006/084478 A1 ist ein Zylinderlinsen-Array zur Homogenisierung von Licht bekannt.

Es ist eine Aufgabe der vorliegenden Erfindung, ein Beleuchtungssystem der eingangs genannten Art derart weiterzubilden, dass die Beleuchtungsintensität über das Beleuchtungsfeld gezielt hinsichtlich der Gesamt-Beleuchtungsintensität und/oder hinsichtlich der Intensitätsbeiträge aus unterschiedlichen Beleuchtungsrichtungen beeinflusst werden kann.

Diese Aufgabe ist erfindungsgemäß gelöst durch ein Beleuchtungssystem mit den im Anspruch 1 angegebenen Merkmalen.

Erfindungsgemäß wurde erkannt, dass eine im Bereich der ersten Rasteranordnung vorgesehene, zusätzlich optisch wirkende Einrichtung, die das Beleuchtungslicht derart beeinflusst, dass der Intensitätsbeitrag von Rasterkanälen der ersten Rasteranordnung zur Gesamt-Beleuchtungs-Intensität über das Beleuchtungsfeld variiert, zusätzliche Freiheitsgrade bei der Gestaltung der feldabhängigen optischen Wirkung des Beleuchtungssystems liefert. Feldabhängige optische Wirkungen anderer Komponenten des Beleuchtungssystems oder auch der Projektionsoptik können mit Hilfe der erfindungsgemäßen zusätzlich optisch wirkenden Einrichtung korrigiert oder kompensiert werden. Zu den korrigierbaren oder kompensierbaren Effekten gehören beispielsweise Transmissionsvariationen optischer Komponenten über deren Durchmesser. Derartige Transmissionsvariationen können durch die erfindungsgemäß zusätzlich wirkende optische Einrichtung beispielsweise vorkompensiert oder überkompensiert werden. Auf diese Weise ist es beispielsweise möglich, das Beleuchtungs- oder Objektfeld des Beleuchtungssystems so auszuleuchten, dass alle Feldpunkte aus allen gewünschten Beleuchtungsrichtungen mit Licht praktisch gleicher Intensität beaufschlagt werden, wobei Intensitätsvariationen über den Beleuchtungswinkel für alle Feldpunkte im Bereich von +/- 1 % liegen. Als Maßgröße für die Gleichmäßigkeit der Beleuchtungswinkel-Beaufschlagung  kann ein Verhältnis aus Intensitäten gebildet werden, mit denen Feldpunkte aus verschiedenen Richtungen bzw. Beleuchtungswinkeln beaufschlagt werden. Dieses Verhältnis wird auch als Elliptizität bezeichnet. Eine mögliche Strahlrichtungsbeeinflussung durch die zusätzlich optisch wirkende Einrichtung ist insbesondere so, dass nicht das gesamte Beleuchtungslichtbündel in gleicher Weise in seiner Strahlrichtung beeinflusst, also abgelenkt wird, sondern dass bestimmte Teil-Lichtbündel des Beleuchtungslichts definiert abgelenkt, geschwächt oder phasenbeeinflusst werden, während andere Teil-Lichtbündel nicht oder anders abgelenkt, geschwächt oder phasenbeeinflusst werden. Eine räumlich benachbarte Zuordnung der zusätzlich optisch wirkenden Einrichtung zur ersten Rasteranordnung ist bei einer Variante des Beleuchtungssystems dadurch gegeben, dass die zusätzlich optisch wirkende Einrichtung als zur ersten Rasteranordnung separate Komponente ausgebildet ist, die in direkter Nachbarschaft der Rasteranordnung vorliegt. Bei einer weiteren Variante des Beleuchtungssystems kann die räumlich benachbart angeordnete zusätzlich optisch wirkende Einrichtung in direktem Kontakt mit der ersten oder einer weiteren Rasteranordnung stehen und beispielsweise als Beschichtung auf mindestens einer der Rasteranordnungen ausgeführt sein. Die Rasterelemente der ersten Rasteranordnung und mindestens einer möglichen weiteren Rasteranordnung sind vorzugsweise refraktiv. Die erste Rasteranordnung muss nicht notwendigerweise monolithisch, also einstückig, auf einem Substrat ausgebildet sein. Es ist auch möglich, dass die erste Rasteranordnung zweistückig ausgebildet ist, wobei die ersten Rasterzeilen auf einem ersten Substrat und die ersten Rasterspalten auf einem zweiten Substrat ausgeformt sind. Zwischen diesen beiden Substraten kann dann insbesondere ein Abstand derart bestehen, dass die zusätzlich optisch wirkende Einrichtung in unmittelbarer Nähe vor der ersten Ebene angeordnet ist, in der die zweidimensionale Intensitätsverteilung des Beleuchtungslichts vorgegeben ist. Bei dieser ersten Ebene handelt es sich insbesondere um eine Pupillenebene des Beleuchtungssystems. Die Feldabhängigkeit der Intensitätsbeiträge kann dann gezielt zu gewünschten Intensitätsüberhöhungen für ausgewählte Beleuchtungswinkel an bestimmten Feldpunkten, zur Intensitätsüberhöhung der Gesamt-Beleuchtungsintensität an bestimmten Feldpunkten oder zu einer Kombination aus beidem eingesetzt werden. Insbesondere kann dies auch Kompensationszwecken zum Ausgleich von sich feldabhängig auswirkenden Transmissionsverlusten in der Beleuchtungs- oder der Projektionsoptik dienen. Zum Beleuchtungssystem kann eine auf eine Beleuchtungsoptik des Beleuchtungssystems angepasste Licht- oder Strahlungsquelle gehören; dies ist aber nicht zwingend. Beim Beleuchtungssystem kann es sich also auch ausschließlich um optische Komponenten handeln, die einer entsprechend angepassten Licht- oder Strahlungsquelle, die separat bereitgestellt wird, nachgeordnet werden. Das Beleuchtungssystem hat eine im Lichtweg benachbart zur ersten Rasteranordnung oder in einer Ebene, die zu einer Ebene optisch konjugiert ist, in der die erste Rasteranordnung angeordnet ist, angeordnete Beleuchtungswinkel-Variationseinrichtung als die zusätzlich optisch wirkende Einrichtung. Diese Beleuchtungswinkel-Variationseinrichtung lenkt Beleuchtungslicht, das auf die Beleuchtungswinkel-Variationseinrichtung trifft, in mindestens zwei Winkelvariationsabschnitten senkrecht zur optischen Achse mit unterschiedlichen Ablenkwinkeln ab. Ein von der Beleuchtungswinkel-Variationseinrichtung erzeugter maximaler Ablenkwinkel ist so groß, dass ein Intensitätsbeitrag von Rasterelementen der ersten Rasteranordnung zur Gesamt-Beleuchtungsintensität über das Beleuchtungsfeld variiert. Bei einer solchen Beleuchtungswinkel-Variationseinrichtung wird ein sonst störender Abbildungsfehler, nämlich die Nichtlinearität der Brechung bei großen Einfallwinkeln, gezielt zur Beeinflussung der Beleuchtungslicht-Intensitätsverteilung über das Beleuchtungsfeld ausgenutzt. Mit den Winkelvariationsabschnitten der Beleuchtungswinkel-Variationseinrichtung werden gezielt Ablenkwinkel eingestellt, wobei zumindest bei den maximalen Ablenkwinkeln, die eingestellt werden können, die paraxiale Näherung bei der Brechung an den Rasterelementen der ersten Rasteranordnung nicht mehr gültig ist. Dies führt zwangsläufig zu feldabhängigen Intensitätsbeiträgen der Rasterelemente, die mit Ablenkwinkeln jenseits der Gültigkeit der paraxialen Näherung beaufschlagt werden. Die Lichtverteilungseinrichtung zur Erzeugung einer vorgegebenen zweidimensionalen Intensitätsverteilung aus dem Beleuchtungslicht in der ersten Ebene senkrecht zur optischen Achse des Beleuchtungssystems sorgt für eine definierte zweidimensionale Intensitätsverteilung in der ersten Ebene. Bei bestimmten Ausführungen des Beleuchtungssystems wird die Lichtverteilungseinrichtung als pupillendefinierendes Element (pupil defining element, PDE) bezeichnet. Die Lichtverteilungseinrichtung kann entfallen, wenn eine vorgegebene Intensitätsverteilung in der ersten Ebene oder in einer hierzu optisch konjugierten Ebene auch auf anderem Wege vorgegeben werden kann. Dies ist zum Beispiel dann der Fall, wenn die vorgegebene Intensitätsverteilung durch die erste Rasteranordnung selbst oder durch die kombinierte optische Wirkung der ersten Rasteranordnung mit mindestens einer möglichen weiteren Rasteranordnung erzeugt wird.

Eine zweite Rasteranordnung nach Anspruch 2 bildet mit der ersten Rasteranordnung ein Rastermodul, welches insbesondere die Form und die Ausleuchtung des Beleuchtungsfeldes vorgibt und daher als felddefinierendes Element (field defining element, FDE) bezeichnet wird. Auf die zweite Rasteranordnung kann insbesondere in Fällen verzichtet werden, in denen an einem in einer Scanrichtung, in der ein Objekt durch das Beleuchtungsfeld geführt wird, führenden oder nachfolgenden Abschnitt des Beleuchtungsfeldes ein definierter Abfall bzw. Anstieg der Beleuchtungsintensität gewünscht ist. Die erste Rasteranordnung kann eine das Beleuchtungslicht sammelnde Wirkung haben, wobei die zweite Rasteranordnung in einer Brennebene der ersten Rasteranordnung angeordnet sein kann. Diese Anordnung der zweiten Rasteranordnung ist jedoch nicht zwingend. Alternativ ist es möglich, die zweite Rasteranordnung gezielt außerhalb der Brennebene der ersten Rasteranordnung anzuordnen, sodass die Rasterelemente der zweiten Rasteranordnung mit ausgedehnten Beleuchtungs-Lichtbündeln des Beleuchtungslichts beaufschlagt werden können.

Eine Beleuchtungswinkel-Variationseinrichtung nach Anspruch 3 führt zur vorstehend schon erwähnten Kombination aus feldabhängigen Intensitätsbeiträgen aus vorgegebenen Beleuchtungsrichtungen sowie gleichzeitig zu einer feldabhängigen Gesamt-Beleuchtungsintensität. Hier werden also mehrere zur Verfügung stehende Freiheitsgrade der feldabhängigen Intensitätsverteilung genutzt.

Eine Beleuchtungswinkel-Variationseinrichtung nach Anspruch 4 zielt auf eine feldabhängige Gesamt-Beleuchtungsintensität ab, wobei über das Feld keine Beleuchtungswinkelabhängigkeit der Intensität vorliegt. Dies kann insbesondere zur Verlustkompensation genutzt werden.

Eine Beleuchtungswinkel-Variationseinrichtung nach Anspruch 5 weist feldabhängige Intensitätsbeiträge aus den verschiedenen Beleuchtungsrichtungen, aber keine Feldabhängigkeit der Gesamt-Beleuchtungsintensität auf. Einzelne Feldpunkte wären also insgesamt jeweils mit gleicher Gesamtintensität, jedoch aus verschiedenen Schwerpunkt-Richtungen bestrahlt. Dies kann zur Abbildung von Strukturen mit Vorzugsrichtungen, die über das Beleuchtungsfeld verteilt sind, genutzt werden. Beleuchtungswinkel-Variationseinrichtungen nach den Ansprüchen 6 und 7 stellen auf die jeweilige Projektionsanwendung abgestimmte Freiheitsgrade hinsichtlich der erzeugbaren Ablenkwinkel zur Verfügung.

Zusätzlich optisch wirkende Einrichtungen nach den Ansprüchen 8 und 9 lassen sich mit mikrooptischen Techniken herstellen. Soweit die zusätzlich optisch wirkende Einrichtung als Variationsbeschichtung ausgeführt ist, kann diese durch Ionenstrahlbearbeitung (Ion Beam figuring (IBF)) hinsichtlich ihrer Schichtstärkenverteilung über die gesamte Apertur des Rastermoduls fein beeinflusst werden. Auch eine hybride Ausgestaltung der Beleuchtungswinkel-Variationseinrichtung ist möglich.

Eine Beleuchtungswinkel-Variationseinrichtung nach Anspruch 10 ist mit hoher Präzision herstellbar.

Die zusätzlich optisch wirkende Einrichtung kann als Rasteranordnung ausgeführt sein, wobei die Rasterung der zusätzlich optisch wirkenden Einrichtung der Rasterung der ersten Rasteranordnung entspricht. Eine solche zusätzlich optisch wirkende Einrichtung erlaubt eine feine Anpassung an eine gewünschte feldabhängige Beleuchtungs-Intensitätsverteilung. Ein Abstand der Beleuchtungswinkel-Variationseinrichtung zur ersten Rasteranordnung kann kleiner sein als der Quotient aus einer Rasterweite der ersten Rasteranordnung und dem maximalen Ablenkwinkel. Eine derartige Ausgestaltung der Beleuchtungswinkel-Variationseinrichtung stellt sicher, dass die ersten Rasterelemente mit abgelenktem Beleuchtungslicht beaufschlagt werden. Einzelne Rasterelemente der Beleuchtungswinkel-Variationseinrichtung können als Keilelemente ausgeführt sein. Derartige Keilelemente lassen sich mit präzise vorgegebenem Keilwinkel herstellen. Einzelne Rasterelemente der Beleuchtungswinkel-Variationseinrichtung können als inverse Dachkanten-Prismen ausgeführt sein. Derartige inverse Dachkanten-Prismen führen zu einer Feldabhängigkeit der Beleuchtungsintensität, die die Ränder der Aperturen der Optiken in der Intensität überhöht. Dies kann zum Ausgleich von randseitigen Verlusten bei der Beleuchtungs- bzw. der Projektionsoptik genutzt werden. Die Beleuchtungswinkel-Variationseinrichtung insgesamt oder einzelne Rasterelemente der Beleuchtungswinkel-Variationseinrichtung können eine brechende Kegelfläche aufweisen, wobei eine Rotationssymmetrieachse der Kegelfläche mit der optischen Achse zusammenfällt oder parallel zu dieser ist.

Derart brechende Kegelflächen führen zu einer rotationssymmetrischen Feldabhängigkeit der Intensität.

Weitere Merkmale zu vorteilhaften Ausgestaltungen der Erfindung ergeben sich aus den nachfolgenden, numerierten Aspekten, die teilweise auf die in den Ansprüchen definierten Gegenstände rückbezogen sind:

13. Beleuchtungssystem nach Anspruch 10, wobei die Beleuchtungswinkel-Variationseinrichtung als symmetrisches Dachkanten-Prisma ausgeführt ist, wobei eine Dachkante (41) des Dachkanten-Prismas die optische Achse senkrecht schneidet und parallel zur Rasterung der ersten Rasteranordnung ausgerichtet ist.

Eine Beleuchtungswinkel-Variationseinrichtung nach Aspekt 13 lässt sich einfach fertigen. Die Ausrichtung der Dachkante ist also entweder parallel zu den Rasterzeilen oder parallel zu den Rasterspalten der ersten Rasteranordnung.

20. Beleuchtungssystem nach einem der Ansprüche 1 bis 11 sowie dem Aspekt 13, wobei der Ablenkwinkel, dem das Beleuchtungslicht, das auf die Beleuchtungswinkel-Variationseinrichtung trifft, unterworfen wird, innerhalb eines Winkelvariationsabschnitts konstant ist.

Ein konstanter Ablenkwinkel innerhalb eines Winkelvariationsabschnittes nach Aspekt 20 vereinfacht die Ausgestaltung der Beleuchtungswinkel-Variationseinrichtung, da die Winkelvariationsabschnitte mit planen Ablenkflächen gestaltet sein können. Alternativ ist es möglich, die Winkelvariationsabschnitte mit sphärischen Oberflächen oder anderen kontinuierlichen Oberflächen, insbesondere mit Freiformflächen, zu gestalten. Auch der Einsatz derartiger, nicht planer Winkelvariationsabschnitte, kann aus fertigungstechnischen Gründen vorteilhaft sein.

21. Beleuchtungssystem nach einem der Ansprüche 1 bis 11 sowie einem der Aspekte 13 sowie 20, wobei die erste Rasteranordnung unterteilt ist in eine Zeilenanordnung mit den ersten Rasterzeilen und in eine Spaltenanordnung mit den ersten Rasterspalten.

Ein Beleuchtungssystem nach Aspekt 21 verringert die Anforderungen, die fertigungstechnisch an die Herstellung der ersten Rasteranordnung zu stellen sind, da die Rasterzeilen und die Rasterspalten separat gefertigt werden können. Auch die zweite Rasteranordnung kann entsprechend in eine Zeilen- und eine Spaltenanordnung unterteilt sein.

22. Beleuchtungssystem nach Aspekt 21, wobei die zusätzlich optisch wirkende Einrichtung zwischen der Spaltenanordnung und der Zeilenanordnung angeordnet ist.

Die Anordnung der zusätzlich optisch wirkenden Einrichtung nach Aspekt 22 hat sich als besonders effektiv herausgestellt, was die gemeinsame bündelführende Wirkung der Beleuchtungswinkel-Variationseinrichtung, der Zeilenanordnung und der Spaltenanordnung angeht.

23. Beleuchtungssystem nach einem der Ansprüche 1 bis 11, sowie einem der Aspekte 13 sowie 20 bis 22, wobei die zusätzlich wirkende optische Einrichtung eine optische Variationsbeschichtung auf Rasterelementen mindestens eines ersten Abschnitts mindestens einer der Rasteranordnungen aufweist, wobei die Variationsbeschichtung derart wirkt, dass Beleuchtungslicht, welches auf die beschichteten Rasterelemente trifft, eine vom Auftreffort auf die Rasterelemente abhängige Transmission und/oder Phasenverschiebung erfährt.

Eine Variationsbeschichtung nach Aspekt 23 kann zur Beeinflussung des Beleuchtungslichts die Krümmung der Auftrefffläche des Rasterelements ausnutzen, auf dem die Variationsbeschichtung aufgebracht ist. In diesem Fall kann die Variationsbeschichtung insbesondere mit konstanter Schichtstärke aufgetragen werden. Eine Änderung der transmissiven Wirkung der Variationsbeschichtung über den Auftreffort ergibt sich durch verschiedene Auftreffwinkel des Beleuchtungslichts, abhängig vom Auftreffort auf den jeweiligen beschichteten Rasterelementen, wobei die Auftreffwinkel von der jeweiligen Strahlrichtung des Beleuchtungslichts und von der Krümmung der Rasterelemente am Auftreffort abhängen. Je nach der effektiv vom Beleuchtungslicht am Auftreffort durchlaufenen Schichtstärke der Variationsbeschichtung ergibt sich eine entsprechende Transmission der Variationsbeschichtung, was zur gewünschten Abhängigkeit vom Auftreffort führt. Entsprechend ist auch eine Phasenbeeinflussung möglich.

24. Beleuchtungssystem nach Aspekt 23, wobei die Variationsbeschichtung derart ausgeführt ist, dass die beschichteten Rasterelemente des ersten Abschnitts für Beleuchtungslicht, welches auf die beschichteten Rasterelemente senkrecht auftrifft, eine geringere Transmission haben als für unter einem kleineren Winkel auftreffendes Beleuchtungslicht.

Eine Auftreffort-Abhängigkeit der Beschichtung nach Aspekt 24 führt zur Überhöhung randseitiger Strahlen. Alternativ und falls dies für eine Kompensation oder Korrektur gewünscht ist, kann die Beschichtung auch so ausgestaltet sein, dass für zentrale Strahlen auf die jeweiligen Rasterelemente eine höhere Transmission resultiert als für die Randstrahlen. In diesem Fall werden die Zentralstrahlen gegenüber den Randstrahlen überhöht.

25. Beleuchtungssystem nach Aspekt 23 oder 24, wobei der erste Abschnitt unterteilt ist in zwei Teilabschnitte, die an gegenüberliegenden Randbereichen der Rasteranordnung liegen.

Bei einer abschnittsweisen Anordnung der optischen Variationsbeschichtung nach Aspekt 25 werden die Randstrahlen von Rasterelement-Kanälen, die von Randbereichen des Rastermoduls ausgehen, überhöht. Dies führt dazu, dass Objektfeldpunkte Beleuchtungslicht aus von der senkrechten Inzidenz stark verschiedenen Beleuchtungswinkeln mit überhöhten Randstrahlen sehen, wenn die Wirkung anderer optischer Komponenten des Beleuchtungssystems außer Acht gelassen wird. Dieser Effekt ist für Kompensations- oder Korrekturzwecke optischer Eigenschaften anderer Komponenten des Beleuchtungssystems von besonderem Interesse, da andere optische Komponenten oftmals so wirken, dass Randstrahlen insbesondere bei extremen Beleuchtungswinkeln gegenüber anderen Strahlen eher unterdrückt werden.

26. Beleuchtungssystem nach einem der Aspekte 23 bis 25, wobei mindestens eine der Rasteranordnungen in mindestens zwei Abschnitte unterteilt ist, wobei mindestens ein erster dieser Abschnitte die Variationsbeschichtung trägt, und mindestens ein weiterer Abschnitt eine weitere optische Beschichtung trägt, deren optische Wirkung sich von derjenigen der Variationsbeschichtung des ersten Abschnitts unterscheidet.

Eine abschnittsweise Anordnung optischer Variationsbeschichtungen unterschiedlicher Wirkung nach Aspekt 26 ermöglicht eine Verstärkung des bildfeldabhängigen Effektes der gesamten optischen Variationsbeschichtung und gibt daher verstärkte Korrekturmöglichkeiten.

27. Beleuchtungssystem nach Aspekt 26, wobei mindestens eine der weiteren optischen Beschichtungen eine vom Auftreffort abhängige optische Wirkung aufweist.

Der vorstehend im Zusammenhang mit dem Aspekt 26 erläuterte Vorteil gilt entsprechend für eine Variationsbeschichtung nach Aspekt 27.

28. Beleuchtungssystem nach Aspekt 26 oder 27, wobei mindestens eine der weiteren optischen Beschichtungen eine vom Auftreffort unabhängige optische Wirkung aufweist.

29. Beleuchtungssystem nach Aspekt 28, wobei der Abschnitt der mindestens einen Rasteranordnung, der die weitere optische Beschichtung mit der vom Auftreffort unabhängigen optischen Wirkung aufweist, einen zentralen Abschnitt darstellt.

Eine Variationsbeschichtung nach Aspekt 28 oder 29 greift hinsichtlich ihrer vom Auftreffort auf die jeweiligen Rasterelemente abhängigen Wirkung nur dort ein, wo dies zu Korrektur- oder Kompensationszwecken erforderlich ist.

30. Beleuchtungssystem nach Aspekt 28 oder 25, wobei zwischen dem zentralen Abschnitt mit vom Auftreffort unabhängiger optischer Wirkung und dem mindestens einen randseitigen Abschnitt mit vom Auftreffort abhängiger Wirkung ein Zwischenabschnitt mit einer optischen Beschichtung liegt, wobei die Abhängigkeit der optischen Wirkung der Beschichtung des Zwischenabschnitts vom Auftreffort schwächer ist als diejenige des randseitigen Abschnitts.

Eine optische Variationsbeschichtung nach Aspekt 30 ermöglicht einen weichen Übergang zwischen Abschnitten mit Beschichtungen unterschiedlicher optischer Wirkung, was in der Regel den zu kompensierenden oder korrigierenden Effekten entspricht.

31. Beleuchtungssystem nach einem der Aspekte 23 bis 30, wobei die Variationsbeschichtung als auf mindestens einem Rasterelement teilweise unterbrochene Schicht ausgeführt ist.

Bei einer Variationsbeschichtung nach Aspekt 31 wird ausgenutzt, dass das Beleuchtungslicht, welches auf unbeschichtete Rasterelemente trifft, in der Regel Reflexionsverluste erleidet. Durch die teilweise Beschichtung kann erreicht werden, dass das Beleuchtungslicht in den beschichteten Bereichen geringere Verluste erleidet, was zur Einstellung von über das Beleuchtungsfeld variierenden Intensitätsbeiträgen genutzt werden kann.

32. Beleuchtungssystem nach einem der Aspekte 23 bis 31, wobei die Variationsbeschichtung eine Schichtdicke oder Schichtabfolge aufweist, die abhängig vom Auftreffort auf dem mindestens einen Rasterelement variiert.

Eine Variationsbeschichtung nach Aspekt 32 nutzt die Transmissionsabhängigkeit von der Schichtdicke und/oder der Schichtabfolge. Die Designparameter "Schichtdickenvariation" und "Schichtabfolgevariation" können zur Einstellung auch komplexerer über das Beleuchtungsfeld variierender Intensitätsbeiträge genutzt werden.

33. Beleuchtungssystem nach einem der Ansprüche 1 bis 11 sowie einem der Aspekte 13 sowie 20 bis 32, wobei die zusätzlich optisch wirkende Einrichtung als Formvariation mindestens einer optisch wirkenden Oberfläche der Rasterelemente der zweiten Rasteranordnung ausgeführt ist, wobei die Formvariation derart wirkt, dass Beleuchtungslicht nach Durchtreten der die Formvariation aufweisenden Rasterelemente eine vom Auftreffort auf die Rasterelemente abhängige Ablenkwinkelverteilung erfährt.

Eine als Formvariation ausgeführte optisch wirkende Einrichtung nach Aspekt 33 nutzt die vom Auftreffort auf den Rasterelementen abhängige Brechung des Beleuchtungslichts und die damit einhergehende Variation der Ablenkwinkelverteilung zur Einstellung eines über das Beleuchtungsfeld variierenden Intensitätsbeitrags. Die Formvariation ist in der Regel statisch, wird also nicht über Aktuatoren aktiv vorgegeben.

34. Beleuchtungssystem nach Aspekt 33, wobei die optisch wirkenden Oberflächen der Rasterelemente mit der Formvariation als Freiformflächen ausgebildet sind.

Mit als Freiformflächen ausgebildeten Formvariationen nach Aspekt 34 lassen sich auch komplex über das Beleuchtungsfeld variierende Intensitätsbeiträge der derartige Formvariationen aufweisenden Rasterelemente realisieren.

35. Beleuchtungssystem nach Aspekt 33 oder 34, wobei die Formvariation der Rasterelemente derart ist, dass die zweite Ableitung der Formvariation eine gerade Funktion ergibt.

36. Beleuchtungssystem nach Aspekt 33 oder 34, wobei die Formvariation der Rasterelemente derart ist, dass die zweite Ableitung der Formvariation eine Funktion mit ungeradem Anteil ergibt.

Eine Formvariation nach den Aspekten 35 und 36 führt zu einem eine entsprechende Symmetrie aufweisenden Intensitätsbeitrag des diese Formvariation aufweisenden Rasterelements über das Beleuchtungsfeld.

37. Beleuchtungssystem nach einem der Ansprüche 1 bis 11 oder einem der Aspekte 13 sowie 20 bis 36, wobei die zusätzlich optisch wirkende Einrichtung als Intensitäts-Variationseinrichtung mit den Rasterelementen der ersten Rasteranordnung zugeordneten Variations-Filterelementen ausgeführt ist, wobei die Variations-Filterelemente derart wirken, dass Beleuchtungslicht, welches nach Durchtreten der Variations-Filterelemente auf die zugeordneten Rasterelemente trifft, eine vom Auftreffort auf diese Rasterelemente abhängige Abschwächung erfährt.

Eine Intensitäts-Variationseinrichtung mit Variations-Filterelementen nach Aspekt 37 nutzt eine gezielt vom Auftreffort auf dem jeweiligen Rasterelement abhängige Abschwächung zur Einstellung eines entsprechenden Intensitätsbeitrags der mit den Variations-Filterelementen ausgerüsteten Rasterelemente über das Beleuchtungsfeld. Auch komplex variierende Intensitätsbeiträge der Rasterelemente lassen sich so einstellen. Es sind Variations-Filterelemente einsetzbar, die sich mit relativ geringem Aufwand herstellen lassen, zum Beispiel Variations-Filterelemente in Form von Graukeilen.

38. Beleuchtungssystem nach Aspekt 37, wobei die Variations-Filterelemente als Absorptions-Filterelenente und/ oder als Reflexions-Filterelemente und/oder als Streu-Filterelemente ausgeführt sind.

Je nach den spezifischen Anforderungen, die an das Beleuchtungssystem gestellt werden, eignen sich absorbierende, reflektierende oder streuende Variations-Filterelemente nach Aspekt 38.

39. Beleuchtungssystem nach Aspekt 38, wobei die Variations-Filterelemente einen für das Beleuchtungslicht transparenten Träger aufweisen, in den für das Beleuchtungslicht absorbierende und/oder reflektierende und/oder streuende Partikel eingelagert sind.

Eingelagerte Partikel nach Aspekt 39 ermöglichen eine feine Beeinflussung der Abschwächung des Variations-Filterelements, insbesondere des Verlaufs der Abschwächung über die Fläche des Variations-Filterelements.

40. Beleuchtungssystem nach Aspekt 39, wobei es sich bei den Partikeln um Metallpartikel, insbesondere um Chrompartikel, handelt.

Metallpartikel, insbesondere Chrompartikel nach Aspekt 40 haben sich gerade bei UV-Beleuchtungslicht als für die Ausgestaltung eines Variations-Filterelements besonders geeignet herausgestellt.

41. Beleuchtungssystem nach Aspekt 38 oder 39, mit einer Ausgestaltung der Variations-Filterelemente derart, dass ein Transmissionsverlauf über die Auftrefffläche des Variations-Filterelements über eine Vorgabe der Partikelhäufigkeit eingestellt ist.

42. Beleuchtungssystem nach einem der Aspekte 39 bis 41, mit einer Ausgestaltung der Variations-Filterelemente derart, dass ein Transmissionsverlauf über die Auftrefffläche des Variations-Filterelements über eine Vorgabe der Partikelgröße eingestellt ist.

Einstellvarianten nach den Aspekten 41 und 42 sind je nach den Verarbeitungseigenschaften der Partikel einerseits und des transparenten Trägers andererseits zur Einstellung des gewünschten Abschwächungsverlaufs der Variations-Filterelemente geeignet.

43. Beleuchtungssystem nach einem der Aspekte 39 bis 42, wobei der Mindestdurchmesser der Partikel größer ist als das 250-fache der Wellenlänge des Beleuchtungslichts.

Ein Mindestdurchmesser nach Aspekt 43 vermeidet störende Beugungseffekte durch die Partikel.

44. Beleuchtungssystem nach einem der Aspekte 39 bis 43, mit einem Mindestdurchmesser der Partikel von 50 $\mu$m.

Ein Mindestdurchmesser nach Aspekt 44 ist insbesondere für UV-Beleuchtungslicht geeignet.

45. Beleuchtungssystem nach einem der Aspekte 37 bis 44, wobei die Intensitäts-Variationseinrichtung Variations-Filterelemente mit unterschiedlicher auftrittsortabhängiger optischer Wirkung aufweist.

Variations-Filterelemente nach Aspekt 45 ermöglichen eine hohe Variationsbandbreite in Bezug auf die beleuchtungsfeldabhängige optische Wirkung des Beleuchtungssystems.

Eine weitere Aufgabe der Erfindung ist es, eine Mikrolithographie-Projektionsbelichtungsanlage mit einem erfindungsgemäßen Beleuchtungssystem zu schaffen sowie ein hiermit durchführbares mikrolithographisches Herstellungsverfahren anzugeben.

Diese Aufgabe ist erfindungsgemäß gelöst durch eine Mikrolithographie-Projektionsbelichtungsanlage nach Anspruch 11 sowie ein Herstellungsverfahren nach Anspruch 12. Vorteile dieser Gegenstände ergeben sich aus den oben im Zusammenhang mit dem Beleuchtungssystem angegebenen Vorteilen. Die Gegenstände der Ansprüche 11 und 12 können auch die vorstehend im Zusammenhang mit den Aspekten 13 sowie 20 bis 45 diskutierten Merkmale aufweisen.

Ausführungsbeispiele der Erfindung werden nachfolgend anhand der Zeichnung näher erläutert. In dieser zeigen:

Fig. 1   schematisch einen Meridionalschnitt durch ein erfindungsgemäßes Beleuchtungssystem innerhalb einer Mikrolithographie-Projektionsbelichtungsanlage mit einer zusätzlich optisch wirkenden Einrichtung in Form einer Beleuchtungswinkel-Variationseinrichtung vor einem Rastermodul mit einer zweistufigen Rasteranordnung;

Fig. 2   stärker im Detail vier Kanäle der zweistufigen Rasteranordnung mit der vorgeschalteten Beleuchtungswinkel-Variationseinrichtung und einer nachgeschalteten Übertragungsoptik zur Übertragung des Beleuchtungslichts von der zweistufigen Rasteranordnung in ein Beleuchtungsfeld, dargestellt am Beispiel einer Feld-Zwischenebene;

Fig. 3   stärker im Detail die beleuchtungsfeldabhängigen Beleuchtungswinkel-Intensitätsverteilungen, die von den vier in der Fig. 2 dargestellten Kanälen im Beleuchtungsfeld erzeugt werden, und die Intensitätsbeiträge dieser vier Kanäle an zwei ausgewählten Feldpunkten;

Fig. 4   im Detail die Abbildung von Einzelbündeln durch einen der Kanäle der zweistufigen Rasteranordnung und die nachgeschaltete Übertragungsoptik nach Fig. 2;

Fig. 5   in einer zu Fig. 2 ähnlichen Darstellung eine weitere Ausführung einer Beleuchtungswinkel-Variationseinrichtung vor der zweistufigen Rasteranordnung und der Übertragungsoptik;

Fig. 6   in einer zu Fig. 3 ähnlichen Darstellung die in den verschiedenen Kanälen erzeugten beleuchtungsfeldabhängigen Intensitätsbeiträge;

Fig. 7   in einer zu Fig. 2 ähnlichen Darstellung eine weitere Ausführung einer Beleuchtungswinkel-Variationseinrichtung mit nachgeordneter zweistufiger Rasteranordnung und Übertragungsoptik;

Fig. 8   eine zu Fig. 1 ähnliche Darstellung eines Beleuchtungssystems mit einer Variante der ersten Stufe der Rasteranordnung;

Fig. 9   in einer zu Fig. 2 ähnlichen Darstellung eine weitere Ausführung einer zusätzlich optisch wirkenden Einrichtung in Form einer Variationsbeschichtung auf der zweiten Stufe der Rastereinrichtung;

Fig. 10   eine Ausschnittsvergrößerung aus Fig. 9 im Bereich der Beschichtung eines Rasterelements der Rasteranordnung;

Fig. 11   schematisch die zweistufige Rasteranordnung nach Fig. 9 aus Blickrichtung XI in Fig. 9;

Fig. 12   den Einfluss verschiedener Stärken der Beschichtung auf dem Rasterelement nach Fig. 10 auf dessen Transmission in einem Diagrämm, welches die Transmission über den Einfallswinkel auf die beschichtete optische Oberfläche des Rasterelements zeigt.

Fig. 13   vergrößert ein Rasterelement des Rastermoduls mit einer weiteren Ausführung einer zusätzlich optisch wirkenden Einrichtung in Form einer Beschichtung;

Fig. 14   die Wirkung des nach Fig. 13 beschichteten Rasterelements in der Feld-Zwischenebene in einer zu Fig. 2 ähnlichen Teildarstellung;

Fig. 15   in einer zu Fig. 13 ähnlichen Darstellung zwei weitere Varianten einer zusätzlich optisch wirkenden Einrichtung in Form einer Variationsbeschichtung;

Fig. 16   in einer zu Fig. 2 ähnlichen Darstellung die optische Wirkung einer weiteren Ausführung einer zusätzlich optisch wirkenden Einrichtung, ausgebildet als Formvariation mindestens einer optisch wirkenden Oberfläche von Rasterelementen des Rastermoduls;

Fig. 17    schematisch eine intensitätsabhängige Beleuchtungswinkelverteilung am Ort a der Feld-Zwischenebene nach Fig. 16;

Fig. 18    schematisch eine intensitätsabhängige Beleuchtungswinkelverteilung am Ort b der Feld-Zwischenebene nach Fig. 16;

Fig. 19    schematisch eine intensitätsabhängige Beleuchtungswinkelverteilung am Ort c der Feld-Zwischenebene nach Fig. 16;

Fig. 20    schematisch einen Beleuchtungskänal der Ausführung nach Fig. 16 zur Erzeugung einer feldabhängigen Intensitätsverteilung, die derjenigen des Kanals I der Anordnung nach Fig. 16 entspricht;

Fig. 21    in einer zu Fig. 2 ähnlichen Darstellung die optische Wirkung einer weiteren Ausführung einer zusätzlich optisch wirkenden Einrichtung, ausgebildet als Formvariation mindestens einer optisch wirkenden Oberfläche von Rasterelementen des Rastermoduls;

Fig. 22    schematisch eine intensitätsabhängige Beleuchtungswinkelverteilung am Ort a der Feld-Zwischenebene nach Fig. 21;

Fig. 23    schematisch eine intensitätsabhängige Beleuchtungswinkelverteilung am Ort b der Feld-Zwischenebene nach Fig. 21;

Fig. 24    schematisch eine intensitätsabhängige Beleuchtungswinkelverteilung am Ort c der Feld-Zwischenebene nach Fig. 21;

Fig. 25    schematisch einen Beleuchtungskanal der Ausführung nach Fig. 21 zur Erzeugung einer feldabhängigen Intensitätsverteilung, die derjenigen des Kanals I der Anordnung nach Fig. 21 entspricht;

Fig. 26    schematisch verschiedene Formvarlationen, die bei den Ausführungen nach den Fig. 16 bis 25 möglich sind;

Fig. 27    in einer zu Fig. 2 ähnlichen Darstellung eine weitere Ausführung einer zusätzlich optisch wirkenden Einrichtung in Form einer Intensitäts-Variationseiririchtung mit Variations-Filterelementen; und

Fig. 28    in einer zu Fig. 2 ähnlichen Darstellung eine weitere Ausführung einer zusätzlich optisch wirkenden Einrichtung in Form einer Beleuchtungswinkel-Variationseinrichtung mit nachgeordneter einstufiger Rasteranordnung und Übertragungsoptik.

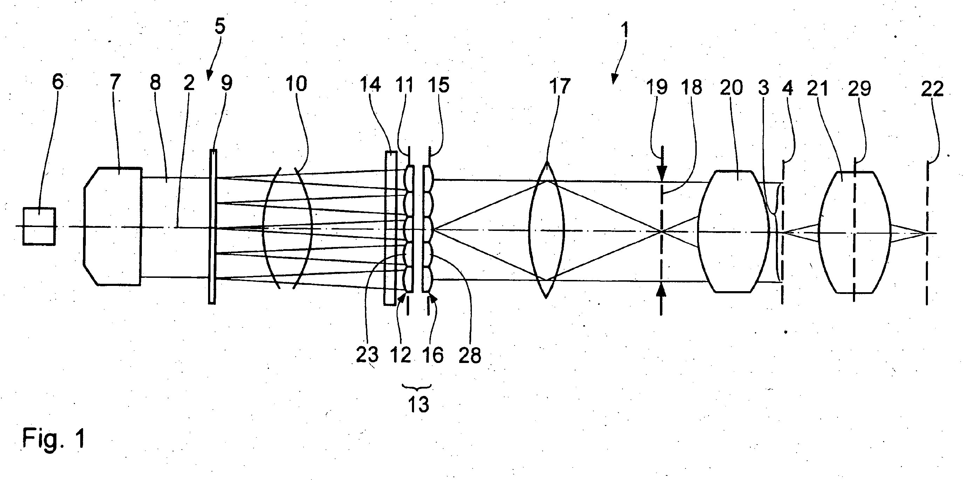

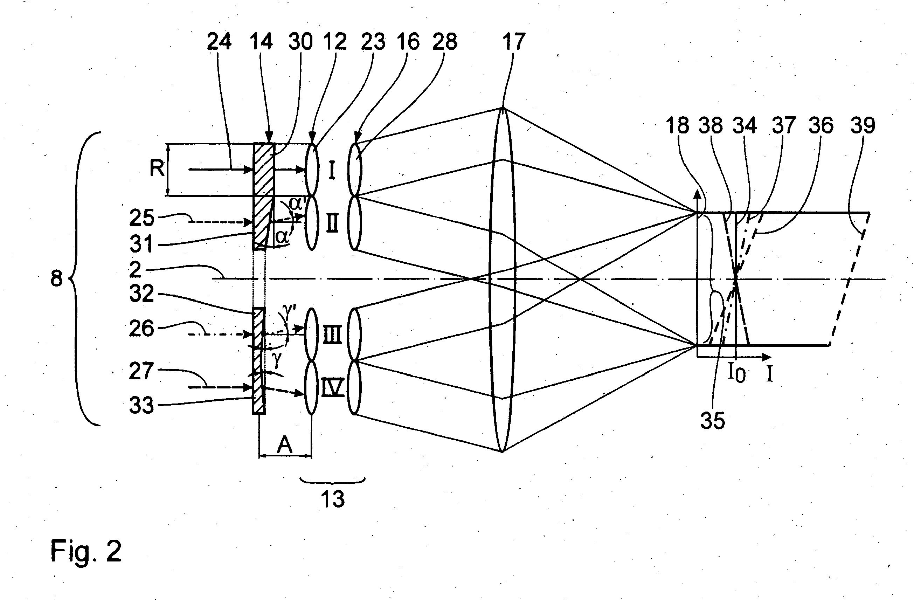

Figur 1 zeigt schematisch eine Mikrölithographie-Projektionsbelichtungsanlage 1, die als Wafer-Scanner ausgeführt ist und bei der Herstellung von Halbleiterbauelementen und anderen fein strukturierten Bauteilen eingesetzt wird. Die Projektionsbelichtungsanlage 1 arbeitet zur Erzielung von Auflösungen bis zu Bruchteilen von Mikrometern mit Licht insbesondere aus dem tiefen Ultraviolettbereich (VUV). Eine Scanrichtung der Projektionsbelichtungsanlage 1 verläuft senkrecht zur Zeichenebene der Fig. 1 und 2. Im in der Figur 1 dargestellten Meridionalschnitt sind alle optischen Komponenten der Projektionsbelichtungsanlage 1 längs einer optischen Achse 2 aufgereiht. Es versteht sich, dass auch beliebige Faltungen der optischen Achse 2 möglich sind, insbesondere um die Projektionsbelichtungsanlage 1 kompakt zu gestalten.

Zur definierten Ausleuchtung eines Objekt- bzw. Beleuchtungsfeldes 3 in einer Retikelebene 4, in der eine zu übertragende Struktur in Form eines nicht näher dargestellten Retikels angeordnet ist, dient ein insgesamt mit 5 bezeichnetes Beleuchtungssystem der Projektionsbelichtungsanlage 1. Als primäre Lichtquelle 6 dient ein $F_2$-Laser mit einer Arbeitswellenlänge von 157 nm, dessen Beleuchtungslichtstrahl koaxial zur optischen Achse 2 ausgerichtet ist. Andere UV-Lichtquellen, beispielsweise ein ArF-Excimer-Laser mit 193 nm Arbeitswellenlänge, ein Krf-Excimer-Laser mit 248 nm Arbeitswellenlänge sowie primäre Lichtquellen mit größeren oder kleineren Arbeitswellenlängen sind ebenfalls möglich.

Der von der Lichtquelle 6 kommende Lichtstrahl mit kleinem Rechteckquerschnitt trifft zunächst auf eine Strahlaufweitungsoptik 7, die einen austretenden Strahl 8 mit weitgehend parallelem Licht und größerem Rechteckquerschnitt erzeugt. Die Strahlaufweitungsoptik 7 kann Elemente enthalten, die zur Kohärenzreduktion des Beleuchtungslichts dienen. Das durch die Strahlaufweitungsoptik 7 weitgehend parallelisierte Laserlicht trifft anschließend auf ein diffraktives optisches Element (DOE) 9, das als computergeneriertes Hologramm zur Erzeugung einer BeleuchtungslichtWinkelverteilung ausgebildet ist. Die durch das DOE 9 erzeugte Winkelverteilung wird beim Durchtritt durch eine Fourier-Linsenanordnung bzw. einen Kondensor 10, der im Abstand seiner Brennweite vom DOE 9 positioniert ist, in eine zweidimensionale, also senkrecht zur optischen Achse 2 ortsabhängige Beleuchtungslicht-Intensitätsverteilung umgewandelt. Die so erzeugte Intensitätsverteilung ist daher in einer ersten Beleuchtungsebene 11 des Beleuchtungssystems 5 vorhanden. Zusammen mit dem Kondensor 10 stellt das DOE 9 also eine Lichtverteilungseinrichtung zur Erzeugung einer zweidimensionalen Beleuchtungslicht-Intensitätsverteilung dar.

Im Bereich der ersten Beleuchtungsebene 11 ist eine erste Rasteranordnung 12 eines Rastermoduls 13 angeordnet, das auch als Wabenkondensor bezeichnet wird. Das Rastermodul 13 dient zusammen mit einer im Lichtweg vor diesem angeordneten Beleuchtungswinkel-Variationseinrichtung 14 zur Erzeugung einer definierten Intensitäts- und Beleuchtungswinkelverteilung des Beleuchtungslichts. Die Beleuchtungswinkel-Variationseinrichtung 14 stellt ein erstes Beispiel für eine optisch wirkende Einrichtung dar, die die Intensität, die Phase oder den Ablenkwinkel des Beleuchtungslichtstrahl 8 beeinflusst. Die optische Wirkung der Beleuchtungswinkel-Variationseinrichtung 14 wird nachfolgend anhand verschiedener Ausführungsbeispiele noch näher erläutert.

In einer weiteren Beleuchtungsebene 15, die eine Fourier-transformierte Ebene zur Beleuchtungsebene 11 ist, ist eine zweite Rasteranordnung 16 angeordnet. Die beiden Rasteranordnungen 12, 16 stellen den Wabenkondensor 13 des Beleuchtungssystems 5 dar. Die weitere Beleuchtungsebene 15 ist eine Pupillenebene des Beleuchtungssystems 5.

Dem Rastermodul 13 nachgeordnet ist ein weiterer Kondensor 17, der auch als-Feldlinse bezeichnet wird. Zusammen mit der zweiten Rasteranordnung 16 bildet der Kondensor 17 die Beleuchtungsebene 11 in eine FeldZwischenebene 18 des Beleuchtungssystems 5 ab. In der Feld-Zwischenebene 18 kann ein Retikel-Masking-System (REMA) 19 angeordnet sein, welches als verstellbare Abschattungsblende zur Erzeugung eines scharfen Randes der Beleuchtungslicht-Intensitätsverteilung dient. Ein nachfolgendes Objektiv 20 bildet die Feld-Zwischenebene 18 auf das Retikel, das heißt die Lithographievorlage ab, das sich in der Retikelebene 4 befindet. Mit einem Projektionsobjektiv 21 wird die Retikelebene 4 auf eine Waferebene 22 auf den in der Figur 1 nicht dargestellten Wafer abgebildet, der intermittierend oder kontinuierlich in der Scan-Richtung verschoben wird.

Anhand der Figuren 2 bis 4 wird nachfolgend eine erste Ausführungsform der Beleuchtungswinkel-Variationseinrichtung 14 beschrieben. Die Beleuchturigswinkel-Variafionseinrichtung 14 ist diffraktiv ausgeführt. Die erste Rasteranordnung 12 weist einzelne erste Rasterelemente 23 auf, die spalten- und zeilenweise angeordnet sind. Die ersten Rasterelemente 23 haben eine rechteckige Apertur mit einem x/y-Aspektverhältnis (y: Scanrichtung) von beispielsweise 2/1. Auch andere, insbesondere größere Aspektverhältnisse der ersten Rasterelemente 23 sind möglich.

Der Meridionalschnitt nach Figur 1 geht entlang einer Rasterspalte. Die ersten Rasterelemente 23 sind insbesondere als Mikrolinsen, z. B. mit positiver Brechkraft, ausgebildet. Die Rechteckform der ersten Rastelemente 23 entspricht der Rechteckform des Beleuchtungsfelds 3. Die ersten Rastelemente 23 sind in einem ihrer Rechteckform entsprechenden Raster direkt aneinander angrenzend, das heißt im Wesentlichen flächenfüllend, angeordnet. Die ersten Rastelemente 23 werden auch als Feldwaben bezeichnet.

Figur 2 zeigt beispielhaft vier erste Rasterelemente 23, die von oben nach unten Kanäle I bis IV für Beleuchtungs-Lichtbündel 24 bis 27 des Beleuchtungslichts 8 vorgeben. Das Beleuchtungs-Lichtbündel 24 ist dabei dem Kanal I, das Beleuchtungs-Lichtbündel 25 dem Kanal II, das BeleuchtungsLichtbündel 26 dem Kanal III und das Beleuchtungs-Lichtbündel 27 dem Kanal IV zugeordnet. Beim realen Rastermodul 13 liegt eine wesentlich höhere Anzahl von Kanälen vor, z. B. einige Hundert derartiger Kanäle. Im Lichtweg hinter den ersten Rasterelementen 23 der ersten Rastanordnung 12 sind, jeweils den Kanälen zugeordnet, zweite Rastelemente 28 der zweiten Rasteranordnung 16 angeordnet. Die zweiten Rastelemente 28 sind ebenfalls als Mikrolinsen mit insbesondere positiver Brechkraft ausgebildet. Die zweiten Rastelemente 28 werden auch als Pupillenwaben bezeichnet, die in der Beleuchtungsebene 15, also in einer Pupillenebene des Beleuchtungssystems 5 angeordnet sind. Die Beleuchtungsebene 15 ist konjugiert zu einer Pupillenebene 29 des Projektionsobjektivs 21. Die zweiten Rastelemente 28 bilden zusammen mit der Feldlinse 17 die in der Beleuchtungsebene 11 angeordneten ersten Rastelemente 23, also die Feldwaben, in die Feld-Zwischenebene 18 ab. Hierbei werden die Bilder der ersten Rastelemente 23 in der Feld-Zwischenebene 18 überlagert.

Die im Lichtweg vor der ersten Rastanordnung 12 angeordnete Beleuchtungswinkel-Variationseinrichtung 14 ist in Winkelvariationsabschnitte unterteilt, wobei jeder Winkelvariationsabschnitt einem Kanal des Rastmoduls 13 zugeordnet ist. Ein Winkelvariationsabschnitt 30 ist dabei dem Kanal I, ein Winkelvariationsabschnitt 31 dem Kanal II, ein Winkelvariationsabschnitt 32 dem Kanal III und ein Winkelvariationsabschnitt 33 dem Kanal IV zugeordnet. Die Ausdehnung jedes Winkelvariationsabschnitts 30 bis 33 senkrecht zur optischen Achse 2 entspricht der rechteckigen Apertur der Kanäle I bis IV. Die Beleuchtungswinkel-Variationseinrichtung 14 stellt daher ebenfalls eine Rasteranordnung dar.

Die Rasterung der Beleuchtungswinkel-Variationseinrichtung 14 der Winkelvariationsabschnitte 30 bis 33 entspricht also der Rasterung der ersten Rasteranordnung 12. Jeder Winkelvariationsabschnitt 30 bis 33 hat eine Apertur, die der Apertur des zugeordneten ersten Rasterelements 23 entspricht.

Der Winkelvariationsabschnitt 30 ist als planparalleles Rastelement ausgeführt, sodass er das einfallende Beleuchtüngs-Lichtbündel 24 nicht ablenkt. Unter der Voraussetzung, dass das Beleuchtungs-Lichtbündel 24 die gesamte Apertur des Kanals I mit gleicher Intensität ausleuchtet, resultiert in der Feld-Zwischenebene 18 ein Intensitätsbeitrag 34 des ersten Kanals I, der über ein Beleuchtungsfeld 35 in der Feld-Zwischenebene 18 konstant einen Wert $I_0$ hat.

Der Winkelvariationsabschnitt 31 der Beleuchtungswinkel-Variationseinrichtung 14, der dem Kanal II zugeordnet ist, ist als sich in der Fig. 2 nach unten verjüngender Keil mit einem ersten Keilwinkel $\alpha$ zwischen einer Eintritts-und einer Austrittsfläche ausgebildet. Hierdurch wird das vor der Beleuchtungswinkel-Variationseinrichtung 14 parallel zur optischen Achse 2 geführte Beleuchtungs-Lichtbündel 25 in der Fig. 2 um einen Winkel $\alpha$' nach oben abgelenkt.

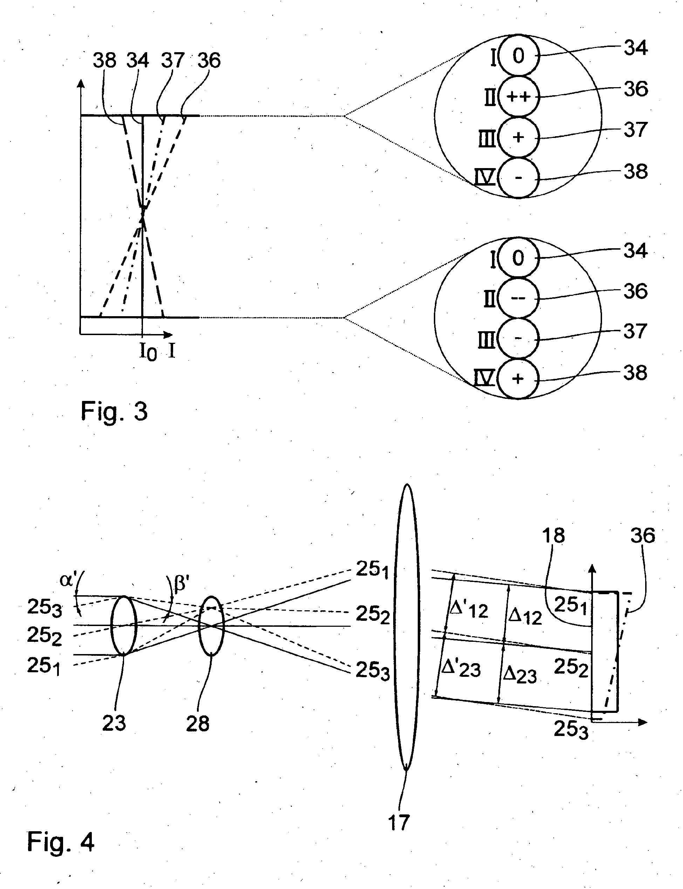

Die Auswirkungen, die diese Ablenkung um den Winkel $\alpha$' auf einen Intensitätsbeitrag 36 des Kanals II im Beleuchtungsfeld 35 hat, werden nun anhand der Figur 4 erläutert. Dabei wird das Beleuchtungs-Lichtbündel 25, das gestrichelt dargestellt ist, in drei Beleuchtungs-Teilbündel $25_1$, $25_2$ und $25_3$, einfallsseitig von unten nach oben durchnummeriert, unterteilt. In der Fig. 4 durchgezogen ist zum Vergleich ein ebenfalls in drei Beleuchtungs-Teilbündel unterteiltes und parallel zur optischen Achse 2 in den Kanal II einfallendes Beleuchtungs-Lichtbündel dargestellt.

Aufgrund des Ablenkwinkels $\alpha$' wird das Beleuchtungs-Teilbündel $25_3$ am ersten Rastelement 23 am stärksten gebrochen. Bei der Brechung des Beleuchtungs-Teilbündels $25_3$ ist die paraxiale Näherung nicht mehr gültig. Daher wird das Beleuchtungs-Teilbündel 25 im Vergleich zu einer aberrationsfreien Abbildung zu stark gebrochen, also um einen Winkel $\beta$' umgelenkt. Die beiden anderen Beleuchtungs-Teilbündel $25_2$ und $25_1$ werden hingegen nur relativ gering gebrochen, sodass dort die paraxiale Näherung noch gilt. Die Abweichung der Brechungs-Ablenkung des Beleuchtungs-Teilbündels $25_3$ von der paraxialen Näherung führt bei der Abbildung der einfallenden Beleuchtungs-Teilbündel $25_1$ bis $25_3$ durch das zweite Rastelement 28 und den Kondensor 17 dazu, dass der Abstand $\Delta_{12}$' zwischen den Beleuchtungs-Teilbündeln $25_1$ und $25_2$ nach dem Kondensor 17 kleiner ist als der Abstand $\Delta_{23}$' zwischen den Beleuchtungs-Teilbündeln $25_2$ und 253. In der Feld-Zwischenebene 18 führt dies dazu, dass der Intensitätsbeitrag 36 des Kanals II am in der Figur 4 oberen Rand des Beleuchtungsfelds 35 am größten ist und dann, ausgehend von einer maximalen Intensität, mit konstanter Steigung linear abfällt bis hin zu einem minimalen Intensität am in der Figur 4 unteren Rand des Beleuchtungsfeldes 35. An diesem linearen Verlauf des Intensitätsbeitrags 36 des Kanals II ändert sich auch durch die Abbildung durch das Projektionsobjektiv 21 nichts, sofern Transmissionsverluste der Optiken vernachlässigt werden.

Die zum Vergleich durchgezogen dargestellten Beleuchtungs-Teilbündel mit in Figur 4 paraxialem Einfall weisen gleiche Abstände $\Delta_{12}$ und $\Delta_{23}$ zwischen den randseitigen Beleuchtungs-Teilbündeln und dem mittleren Beleuchtungs-Teilbündel auf.

Der Winkelvariationsabschnitt 32 der Beleuchtungswinkel-Variationseinrichtung 14, der dem Kanal III zugeordnet ist, hat einen austrittsseitigen Keilwinkel $\gamma$, der kleiner ist als der Keilwinkel $\alpha$. Der Winkelvariationsabschnitt 32 verjüngt sich in der Fig. 2 keilförmig nach unten. Dies führt dazu, dass ein Ablenkwinkel $\gamma$', den das Beleuchtungs-Lichtbündel 26 durch den Winkelvariationsabschnitt 32 erfährt, geringer ist als der Ablenkwinkel $\alpha$', der durch den Winkelvariationsabschnitt 31 erzeugt wird. Entsprechend resultiert ein geringerer Unterschied in den Abständen zwischen den beiden randseitigen Beleuchtungs-Teilbündeln und dem mittleren Beleuchtungs-Teilbündel im Kanal III, sodass ein Intensitätsbeitrag 37 des Kanals III resultiert, der über das Beleuchtungsfeld 35 in der Fig. 2 von oben nach unten linear mit geringerer Steigung abfällt als der Intensitätsbeitrag 36 des Kanals II.

Die maximale Intensität des Intensitätsbeitrags 37 am oberen Rand des Beleuchtungsfeldes 35 ist dabei geringer als die maximale Intensität des Intensitätsbeitrags 36. Die minimale Intensität des Intensitätsbeitrages 37 des Kanals III ist hingegen größer als die minimale Intensität des Intensitätsbeitrags 36 des Kanals II.

Der Winkelvariationsabschnitt 33 des Kanals IV ist als sich in der Fig. 2 nach oben verjüngender Keil mit einem Keilwinkel $\gamma$ zwischen Eintritts-und Austrittsfläche ausgebildet, der in seinem Absolutbetrag dem Keilwinkel $\gamma$ des Winkelvariationsabschnitts 32 des Kanals III entspricht. Es resultiert ein linear über das Beleuchtungsfeld variierender Intensitätsbeitrag 38 des Kanals IV, der dem Intensitätsbeitrag 37, gespiegelt um die optische Achse 2, entspricht. Beim Intensitätsbeitrag 38 des Kanals IV liegt die minimale Intensität also am in der Fig. 2 oberen Feldrand und die maximale Intensität an der in der Fig: 2 unteren Feldrand vor. Die feldrandseitigen minimalen und maximalen Intensitäten der Intensitätsbeiträge 37 und 38 sind vom Absolutbetrag her in etwa gleich.

Fig. 3 verdeutlicht den Effekt der Beleuchtungswinkel-Variationseinrichtung 14 über das Beleuchtungsfeld 35. In der Fig. 3 links sind nochmals die Intensitätsbeiträge 34 sowie 36-38 der Kanäle I-IV dargestellt. Rechts in der Fig. 3 sind die Intensitäten der einzelnen Intensitätsbeiträge 34 sowie 36-38 an ausgewählten Feldpunkten am oberen Rand des Beleuchtungsfeldes 35 sowie am unteren Rand des Beleuchtungsfeldes 35 anschaulich dargestellt.

Am oberen Rand des Beleuchtungsfeldes 35 leistet der Kanal I einen Intensitätsbeitrag Io, der durch "0" veranschaulicht wird. Die Intensität des Intensitätsbeitrags 36 ist am oberen Rand des Beleuchtungsfeldes 35 maximal, was durch "++" veranschaulicht wird. Die Intensität des Intensitätsbeitrags 37 des Kanals III ist am oberen Feldrand ebenfalls maximal, aber geringer als diejenige des Intensitätsbeitrags 36 des Kanals II, was durch "+" veranschaulicht wird. Die Intensität des Intensitätsbeitrags 38 des Kanals IV ist am oberen Feldrand am geringsten, was durch "-" veranschaulicht wird.

Am oberen Feldrand liegt also eine Intensitätszusammensetzung aus den möglichen Beleuchtungsrichtungen der Kanäle I-IV vor, bei der der Kanal II am stärksten beiträgt, gefolgt vom Intensitätsbeitrag des Kanals III und dem Intensitätsbeitrag des Kanals I. Am schwächsten ist der Intensitätsbeitrag des Kanals IV.

Umgekehrt sind die Verhältnisse am unteren Feldrand des Beleuchtungsfeldes 35, wie in der Fig. 3 rechts unten dargestellt. Die Intensität des Intensitätsbeitrags 34 des Kanals I beträgt dort ebenfalls $I_0$, was durch "0" angedeutet ist. Die Intensität des Intensitätsbeitrags 36 des Kanals II hat dort das absolute Minimum, was durch "- -" angedeutet ist. Auch die Intensität des Intensitätsbeitrags 37 des Kanals III hat am unteren Feldrand ein absolutes Minimum. Diese Minimalintensität des Intensitätsbeitrags 37 ist aber größer als die Minimalintensität des Intensitätsbeitrags 36, so dass die Minimalintensität des Kanals III am unteren Feldrand durch "-" verdeutlicht ist. Der Intensitätsbeitrag 38 des Kanals IV hat am unteren Feldrand ein Maximum, dessen Absolutbetrag dem Maximum des Intensitätsbeitrags 37 am oberen Feldrand entspricht. Der Intensitätsbeitrag des Kanals IV am unteren Feldrand ist also durch ein "+" verdeutlicht.

Am unteren Feldrand des Beleuchtungsfeldes 35 liegt also eine Intensitätszusammensetzung vor, bei der der Intensitätsbeitrag 38 des Kanals IV am stärksten ist, gefolgt vom Intensitätsbeitrag 34 des Kanals I, dem Intensitätsbeitrag 37 des Kanals III und dem Intensitätsbeitrag 36 des Kanals II.

Die Intensitätszusammensetzungen der unterschiedlichen Intensitätsbeiträge aus den möglichen Beleuchtungsrichtungen, also den Kanälen I-IV, sind also am oberen Feldrand und am unteren Feldrand verschieden. Entsprechende Intensitätszusammensetzungen der Intensitätsbeiträge aus den möglichen Beleuchtungsrichtungen ergeben sich für Feldpunkte zwischen dem oberen und dem unteren Rand des Beleuchtungsfeldes 35. Mit zunehmendem Abstand der Beleuchtungsfeldpunkte von den Rändern des Beleuchtungsfeldes 35 verringern sich die Unterschiede der Intensitätsbeiträge 36, 37 und 38 zur Intensität $I_0$ des Intensitätsbeitrages 34. In der Mitte zwischen den Rändern des Beleuchtungsfeldes 35 tragen alle Kanäle I-IV mit der gleichen Intensität $I_0$ zur Gesamt-Beleuchtungsintensität am jeweiligen Feldpunkt bei.

Alle Feldpunkte des Beleuchtungsfelds 35 werden also aus allen Kanälen I-IV beleuchtet, allerdings mit unterschiedlichen Intensitätsbeiträgen aus den möglichen Beleuchtungsrichtungen.

Neben den Kanälen I-IV können natürlich noch andere Kanäle mit unterschiedlichen Keilwinkeln vorhanden sein. Da unter den vier Kanälen I-IV der Darstellung nach Fig. 2 zwei Winkelvariationsabschnitte sind, die sich nach unten verjüngen, nämlich die Winkelvariationsabschnitte 31 und 32, wohingegen sich nur ein Winkelvariationsabschnitt, nämlich der Winkelvariationsabschnitt 33, nach oben verjüngt, resultiert auch eine feldabhängige Beleuchtungswinkel-Gesamtintensitätsverteilung. Letztere ist in der Fig. 2 gestrichelt bei 39 angedeutet und ergibt sich als Superposition der Intensitätsverteilungen 34 sowie 36 bis 38.

Der Abstand A der Beleuchtungswinkel-Variationseinrichtung 14 zur ersten Rasteranordnung 12 ist kleiner als der Quotient aus der Rasterweite R des ersten Rasterelements 12 und dem maximalen Ablenkwinkel $\alpha'$. Dies stellt bei einer entsprechenden Ausleuchtung der Winkelvariationsabschnitte 30 bis 33 durch die Beleuchtungs-Lichtbündel 24 bis 27 sicher, dass praktisch das gesamte Beleuchtungslichtbündel 24 bis 27 das zugeordnete Rasterelement 23 der ersten Rasteranordnung 12 trotz der Ablenkung durch die Beleuchtungswinkel-Variationseinrichtung 14 erreicht.

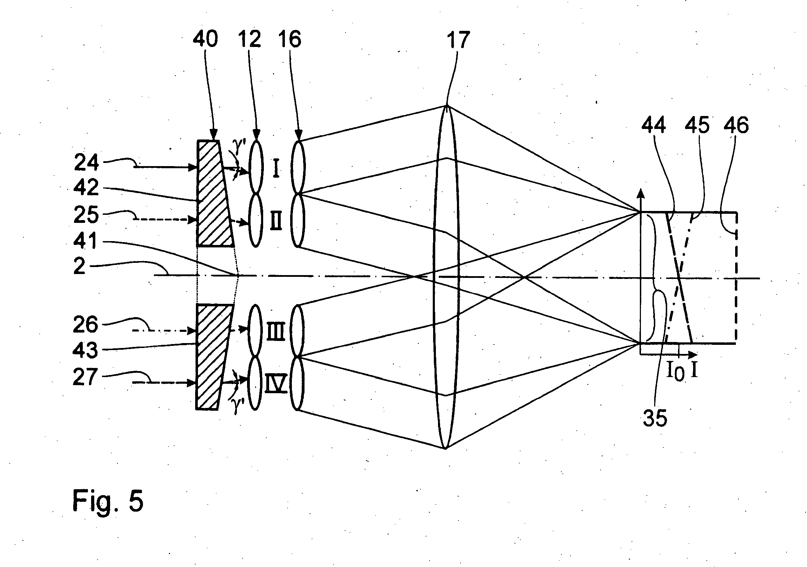

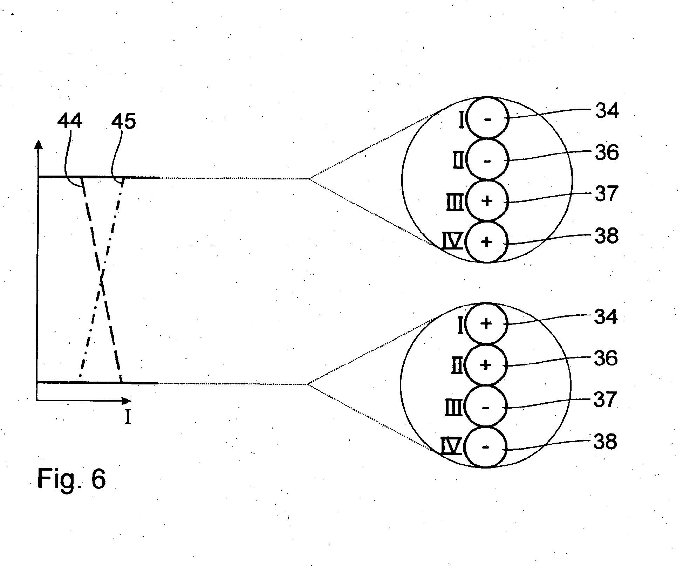

Eine weitere Ausführung einer Beleuchtungswinkel-Variationseinrichtung, die anstelle der Beleuchtungswinkel-Variationseinrichtung 14 zum Einsatz kommen kann, ist in der Fig. 5 dargestellt. Diese Ausführung wird nachfolgend anhand der Fig. 5 und 6 beschrieben. Komponenten, die denjenigen entsprechen, die vorstehend schon unter Bezugnahme auf die Fig. 2 bis 4 erläutert wurden, tragen die gleichen Bezugsziffern und werden nicht nochmals im Einzelnen erläutert.

Die Beleuchtungswinkel-Variationseinrichtung 40 ist als Dachkanten-Prisma ausgeführt mit einer Dachkante 41, die die optische Achse 2 schneidet und senkrecht auf der Zeichenebene der Fig. 5 liegt. Die Beleuchtungswinkel-Variationseinrichtung 40 weist lediglich zwei Winkelvariationsabschnitte 42,43 auf, nämlich einen sich keilförmig nach oben verjüngenden Winkelvariationsabschnitt 42 in Fig. 5 oberhalb der Dachkante 41 und einen sich keilförmig nach unten verjüngenden Winkelvariationsabschnitt 43 in Fig. 5 unterhalb der Dachkante 41. Durch diese Form der Beleuchtungswinkel-Variationseinrichtung 40 ergibt sich für die Kanäle I und II durch den Winkelvariationsabschnitt 42 eine Ablenkung um einen Winkel $\gamma'$ nach unten und führt die Kanäle III und IV durch den Winkelvariationsabschnitt 43 eine Ablenkung um einen Winkel $\gamma'$ nach oben. Dieser Ablenkwinkel $\gamma'$ entspricht vom Absolutbetrag her dem Ablenkwinkel $\gamma'$, den die Winkelvariationsabschnitte 32, 33 der Beleuchtungswinkel-Variationseinrichtung 14 nach Fig. 2 erzeugen.

Intensitätsbeiträge 44 der Kanäle I und II sind praktisch identisch und entsprechen von ihrem Verlauf über das Beleuchtungsfeld 35 her dem Verlauf des Intensitätsbeitrags 38 der Ausführung nach Fig. 2. Intensitätsbeiträge 45 der Kanäle III und IV sind praktisch identisch und entsprechen von ihrem Verlauf her dem Intensitätsbeitrag 37 der Ausführung nach Fig. 2.

Wie in der Fig. 6 dargestellt, wird der obere Rand des Beleuchtungsfelds 35 bei der Ausführung mit der Beleuchtungswinkel-Variationseinrichtung 40 von den Kanälen I und II mit minimaler und von den Kanälen III und IV mit maximaler Intensität beaufschlagt. Entsprechend umgekehrt wird der untere Rand des Beleuchtungsfelds 35 von den Kanälen I und II mit maximaler und von den Kanälen III und IV mit minimaler Intensität beaufschlagt. Zwischen den Feldrändern reduziert sich der Intensitätsunterschied zwischen den Intensitätsbeiträgen der Kanäle I und II einerseits und den Intensitätsbeiträgen der Kanäle III und IV andererseits linear, bis in der Feldmitte alle Kanäle I bis IV mit gleichen Intensitäten zur Gesamtintensität beitragen.

Da der Absolutbetrag der Keilwinkel γ' der Winkelvariationsabschnitte 42, 43 gleich ist, ist auch der Absolutwert der Steigung der Intensitätsbeiträge 44, 45 über das Beleuchtungsfeld 35 gleich. Unter der Voraussetzung, dass die Kanäle I bis IV bei der Beleuchtungswinkel-Variationseinheit 40 gleiche Lichtintensitäten transportieren, folgt hieraus eine Gesamt-Intensitätsverteilung 46, die über das gesamte Beleuchtungsfeld 35 konstant, also feldunabhängig ist. Unterschiedliche Beleuchtungsfeldpunkte werden aber auch bei der Beleuchtungswinkel-Variationseinrichtung 40 mit unterschiedlichen Intensitätsbeiträgen, nämlich entsprechend den Intensitätsbeiträgen 44, 45 aus den möglichen Beleuchtungsrichtungen, also aus Richtung der Kanäle I bis IV, beleuchtet. Die über das Beleuchtungsfeld 35 unterschiedlich geneigten linearen Intensitätsbeiträge 44, 45 heben sich aber bei der Gesamtintensitäts-Betrachtung genau auf, sodass die GesamtIntensitätsverteilung, nicht aber die Winkelverteilung, feldunabhängig ist.

Anstelle eines Dachkanten-Prismas kann die Beleuchtungswinkel-Variationseinrichtung 14 auch als brechende Kegelfläche ausgeführt sein, deren Querschnitt dem entspricht, der in der Fig. 5 dargestellt ist. Es resultiert dann auch senkrecht zur Zeichenebene der Fig. 5 ein Intensitätsverlauf mit Intensitätsbeiträgen 44, 45 entsprechend dem, was in der Fig. 5 dargestellt ist.

Winkelvariationsabschnitte mit Keilwinkel entsprechend den Winkelvariationsabschnitten 42, 43 können auch durch Keilstufen vergleichbar einer Fresnel-Linse derart erzeugt werden, dass die Gesamtdicke der Beleuchtungswinkel-Variationseinrichtung in einer Ebene senkrecht zur optischen Achse 2 im Mittel konstant bleibt. Diese Variante der Beleuchtungswinkel-Variationseinrichtung 40 weist dann ein Raster aus Winkelvariations-Unterabschnitten mit jeweils gleichem Keilwinkel über die Winkelvariationsabschnitte 42, 43 auf.

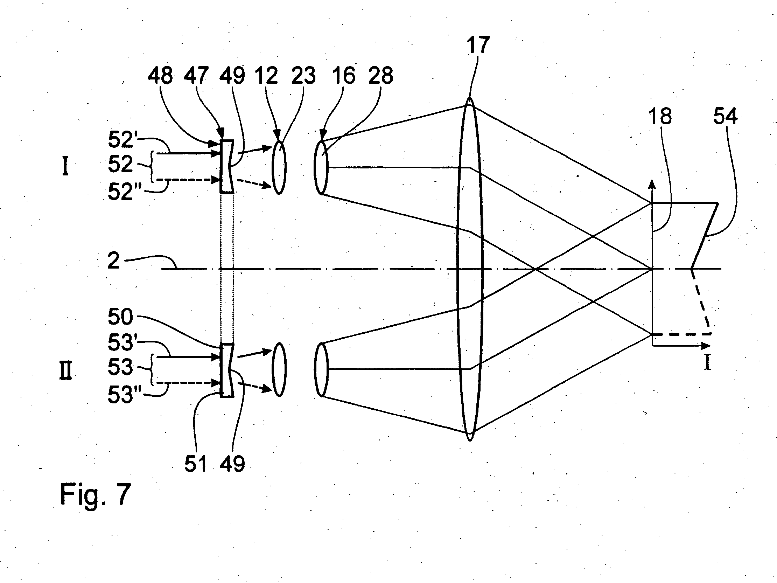

Fig. 7 zeigt eine weitere Ausführung eines Rastermoduls mit einer Beleuchtungswinkel-Variationseinrichtung 47, die anstelle der Beleuchtungswinkel-Variationseinrichtung 14 zum Einsatz kommen kann. Komponenten, die denjenigen entsprechen, die vorstehend schon unter Bezugnahme auf die Fig. 5 und 6 erläutert wurden, tragen die gleichen Bezugsziffern und werden nicht nochmals im Einzelnen diskutiert. Die Ausführung der Beleuchtungswinkel-Variationseinrichtung 47 wird beispielhaft anhand eines oberen Kanals I und eines unteren Kanals II des Rastermoduls 13 erläutert.

Die Beleuchtungswinkel-Variationseinrichtung 47 ist als Rasteranordnung von Winkelvariationsabschnitten 48 ausgeführt, deren Rasterung derjenigen der ersten Rasteranordnung 12 entspricht. Die Apertur des Winkelvariationsabschnitts 48 entspricht daher der Apertur eines ersten Rasterelements 23. Jeder Winkelvariationsabschnitt 48 ist als inverses Dachkanten-prisma mit einer Dachkante 49 ausgeführt, die mittig zwischen den Rändern jedes Winkelvariationsabschnitts 48 in der Austrittsfläche angeordnet ist und senkrecht auf der Zeichenebene der Fig. 7 steht. In der Fig. 7 oberhalb der Dachkanten 49 ist ein sich nach oben keilförmig erweiternder erster Winkelvariations-Unterabschnitt ausgebildet. Unterhalb jeder Dachkante 49 ist ein sich in der Fig. 7 nach unten keilförmig erweiternder zweiter Winkelvariations-Unterabschnitt 51 ausgebildet.

Auf die Winkelvariationsabschnitte 48 der Kanäle I und 11 treffen Beleuchtungs-Lichtbündel 52, 53, die in der Fig. 7 zur Veranschaulichung unterteilt sind in ein durchgezogenes oberes Beleuchtungs-Teilbündel 52', 53' und gestrichelt in ein unteres Beleuchtungs-Teilbündel 52", 53". Die oberen Beleuchtungs-Teilbündel 52', 53' werden durch die ersten Winkelvariations-Unterabschnitte 50 um einen Winkel γ' nach oben und die unteren Beleuchtungs-Teilbündel 52", 53" durch die Winkelvariations-Unterabschnitte 51 um einen Winkel γ' nach unten abgelenkt. Jeder Winkelvariationsabschnitt 48 trägt zur Beleuchtungsintensität im Beleuchtungsfeld 35 mit einem in seiner Abhängigkeit über das Beleuchtungsfeld 35 gleichen Intensitätsbeitrag 54 bei. Vom oberen Rand des Beleuchtungsfeldes 35 bis zur Mitte hin fällt dieser einzelne-Intensitätsbeitrag bzw. die gesamte Intensitätsverteilung 54, die alle Winkelvariationsabschnitte 48 zusammen erzeugen, zunächst linear von einer maximalen auf eine minimale Intensität ab und steigt dann linear bis zum unteren Rand des Beleuchtungsfeldes 35 von der minimalen auf die maximale Intensität an. Die Intensitätsverteilung 54 hat also eine Form, die dem Querschnitt eines einzelnen Winkelvariationsabschnitts 48 entspricht.

Im Beleuchtungsfeld 35 liegt also eine beleuchtungsfeldabhängige GesamtIntensitätsverteilung 54 vor, wobei, da alle Kanäle gleich beitragen, unterschiedliche Beleuchtungsfeldpunkte mit gleichen Intensitäten aus den möglichen Beleuchtungsrichtungen beleuchtet werden.

Anstelle von als inverse Dachkanten-Prismen ausgeführten Winkelvariationsabschnitten wie bei der Ausführung nach Fig. 7 können die Winkelvariationsabschnitte bei einer anderen Ausgestaltung der Beleuchtungswinkel-Variationseinrichtung auch als Rasterelemente mit einer brechenden Kegelfläche ausgestaltet sein. Eine Rotationssymmetrieachse der jeweiligen Kegelfläche ist dabei parallel zur optischen Achse 2 oder fällt mit dieser zusammen. Dies führt zu einer Gesamtintensitätsverteilung, die der Intensitätsverteilung 54 entspricht, jedoch auch in der zur Fig. 7 senkrechten Richtung eine Dachkanten-Abhängigkeit zeigt. Die Gesamtintensität nimmt also bei dieser Variante von einem Minimum in der Mitte des Beleuchtungsfeldes 35 zum Rand hin linear zu. Mit einer derartigen Ausgestaltung der Beleuchtungswinkel-Variationseinrichtung bzw. der Beleuchtungswinkel-Variationseinrichtung 47 kann ein Ausgleich von Transmissionsverlusten an den Apertur-Rändern der Optiken des Beleuchtungsbildsystems 5 oder des Beleuchtungsobjektivs 21 erzielt werden.

Die durch die Beleuchtungswinkel-Variationseinrichtungen 14, 40 und 47 im Beleuchtungsfeld 35 in der Feld-Zwischenebene 18 hervorgerufenen Beleuchtungslicht-Intensitätsverteilungen werden mit dem Abbildungs- maßstab des Objektivs 20 in das Beleuchtungsfeld 3 in der Retikelebene 4 abgebildet.

Nicht dargestellte Varianten der Beleuchtungswinkel-Variationseinrichtungen können refraktiv oder hybrid ausgeführt sein.

Mit Hilfe des Projektionsobjektivs 21 der Projektionsbelichtungsanlage 1 wird wenigstens ein Teil des Retikels auf einen Bereich einer lichtempfindlichen Schicht auf dem Wafer bzw. Substrat zur mikrolithographischen Herstellung eines mikrostrukturierten Bauelements abgebildet.

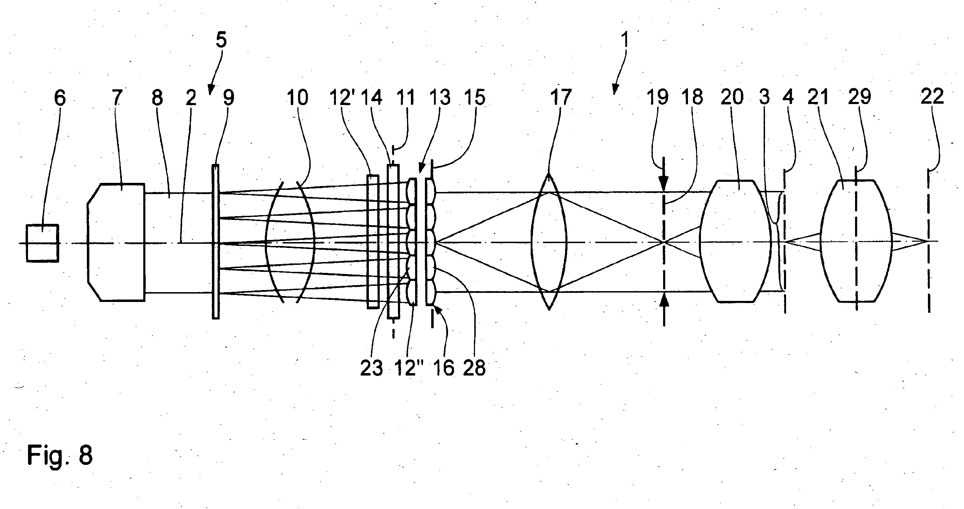

Fig. 8 zeigt eine Variante der Mikrolithografie-Projektionsbelichtungsanlage 1, die sich von derjenigen nach Fig. 1 nur im Aufbau der Rasteranordnung 12 sowie in der Anordnung der Beleuchtungswinkel-Variationseinrichtung 14 relativ zur Rasteranordnung 12 und zur ersten Beleuchtungsebene 11 unterscheidet. Bei der Ausgestaltung nach Fig. 8 ist die erste Rasteranordnung 12 unterteilt in eine Spaltenanordnung 12' mit Rasterelementen, die die ersten Rasterspalten bilden, und in eine Zeilenanordnung 12" mit Rasterelementen, die die ersten Rasterzeilen bilden. Im Unterschied zur ersten Rasteranordnung 12 nach Fig. 1 ist die Rasteranordnung 12', 12" nach Fig. 8 also nicht monolithisch aufgebaut, sondern unterteilt in zwei Elemente, wobei eines die Rasterzeilen und das andere die Rasterspalten ausbildet. Die gemeinsame Wirkung der Spaltenanordnung 12' und der Zeilenanordnung 12" entspricht der Wirkung der ersten Rasteranordnung 12 nach Fig. 1.

Bei der Ausführung nach Fig. 8 ist die Beleuchtungswinkel-Variationseinrichtung 14 zwischen der Spaltenanordnung 12' und der Zeilenanordnung 12" im Bereich der ersten Beleuchtungsebene 11 angeordnet. In der dargestellten Ausführung nach Fig. 8 ist die Spaltenanordnung 12' knapp vor, die Beleuchtungswinkel-Variationseinrichtung 14 in und die Zeilenanordnung 12" knapp hinter der ersten Beleuchtungsebene 11 angeordnet. Der Abstand der Spaltenanordnung 12' und der Zeilenanordnung 12" zur Beleuchtungsebene 11 ist dabei so gering, dass er hinsichtlich der optischen Wirkung dieser beiden Anordnungen 12', 12" nicht ins Gewicht fällt.

Alternativ zur Anordnung nach Fig. 8 können die Spaltenanordnung 12' und die Zeilenanordnung 12" auch vertauscht sein.

Bei einer weiteren, in der Zeichnung nicht dargestellten Variante ist auch die zweite Rasterordnung 16 unterteilt in eine Zeilenanordnung und eine Spaltenanordnung.

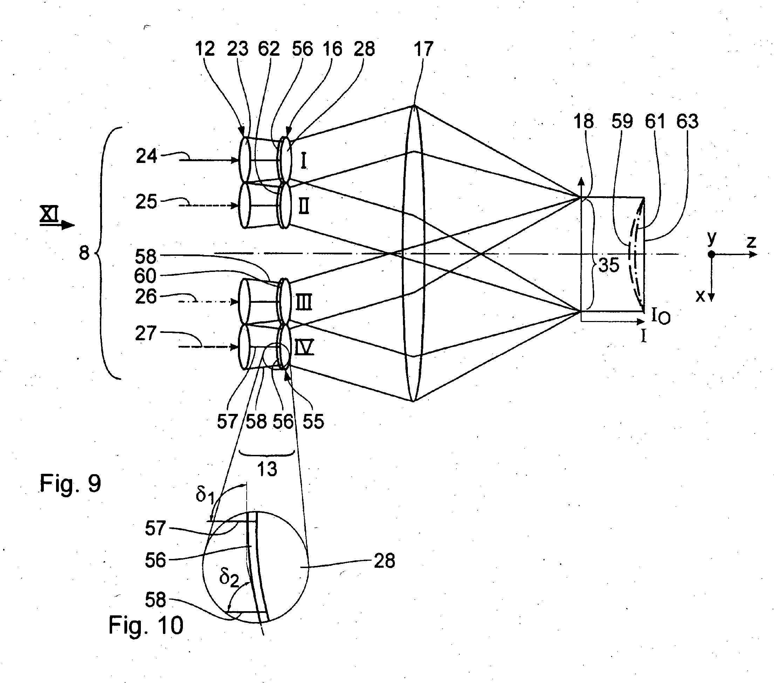

Fig. 9 zeigt ein Rastermodul 13 mit einer weiteren Variante einer optisch wirkenden Einrichtung zur Beeinflussung von Intensitätsbeiträgen der Rasterelemente 23, 28 zur Gesamt-Beleuchtungsintensität über das Beleuchtungsfeld 35. Komponenten und Bezugsgrößen, die denjenigen entsprechen, die vorstehend schon unter Bezugnahme auf die Fig. 1 bis 8 erläutert wurden, tragen die gleichen Bezugsziffern und werden nicht nochmals im Einzelnen diskutiert.

Anstelle einer Beleuchtungswinkel-Variationseinrichtung nach den Fig. 1 bis 8 ist bei der nicht erfindungsgemäßen Ausführung nach den Fig. 9 bis 12 die optisch wirkende Einrichtung zur Beeinflussung der Eigenschaften des Beleuchtungslichtstrahls 8 ausgebildet als optische Variationsbeschichtung 55 auf den zweiten Rasterelementen 28 der zweiten Rasteranordnung 16. Die Variationsbeschichtung 55 ist dabei auf der der ersten Rasteranordnung 12 zugewandten Seite der zweiten Rasteranordnung 16 aufgetragen. Jedes der zweiten Rasterelemente 28 trägt dabei eine individuelle Transmissionsbeschichtung. Die Transmissionsbeschichtungen sind beispielsweise als Interferenzschichten ausgeführt. Die Dicke der jeweiligen Transmissionsbeschichtung kann durch Ionenstrahlbearbeitung (Ion Beam Figuring, IBF) fein beeinflusst werden. Die Wirkung einer dieser Transmissionsbeschichtungen, nämlich der Transmissionsbeschichtung 56 des in der Fig. 9 unten (Kanal IV) dargestellten zweiten Rasterelements 28, wird nachfolgend unter Zuhilfenahme der Ausschnittsvergrößerung nach Fig. 10 erläutert.

Das Beleuchtungs-Lichtbündel 27 des Kanals IV wird vom ersten Rasterelement 23 des Kanals IV in Richtung auf das zweite Rasterelement 28 des Kanals IV gebündelt. Ein Zentralstrahl 57 des Beleuchtungs-Lichtbündels 27 wird dabei von dem ersten Rasterelement 23 nicht abgelenkt und trifft daher senkrecht auf die Transmissionsbeschichtung 56 und auf das zweite Rasterelement 28. Ein Wirikel $\delta_1$ zwischen dem Zentralstrahl 57 und einer Tangente zum Auftreffpunkt des Zentralstrahls 57 auf die Transmissionsbeschichtung 56 beträgt daher 90°.

Aufgrund der Krümmung des zweiten Rasterelements 28 ist der Winkel zwischen einem Randstrahl 58 des Beleuchtungs-Lichtbündels 27 und einer Tangente zum Auftreffpunkt dieses Randstrahls 58 auf die Transmissionsbeschichtung 56, $\delta_2$, kleiner als 90°. Daher ist der effektive optische Weg des Zentralstrahls 57 durch die Transmissionsbeschichtung 56 kleiner als der effektive Weg des Randstrahls 58 durch die Transmissionsbeschichtung 56. Die Transmissionsbeschichtung 56 hat also für randseitige Strahlen des Beleuchtungs-Lichtbündels 27 eine andere transmissive Wirkung als für den Zentralstrahl 57. Das Beleuchtungs-Lichtbündel 27 erfährt also eine vom Auftreffort auf das zweite Rasterelement 28 abhängige Transmission.

Die Transmissionsbeschichtung 56 hat auf dem gesamten zweiten Rasterelement 28 die gleiche Schichtstärke. Diese Konstanz der Schichtstärke über das jeweilige zweite Rasterelement 28 gilt für die gesamte Variationsbeschichtung 55, wobei die Schichtstärken der Transmissionsbeschichtungen für die individuellen zweiten Rasterelemente 28 voneinander verschieden sein können.

Die Stärke der Transmissionsbeschichtung 56 ist so gewählt, dass die Transmission der Transmissionsbeschichtung 56 für den Zentralstrahl 57 geringer ist als für die Randstrahlen 58. Ein Intensitätsbeitrag 59 des Kanals IV über das Beleuchtungsfeld 35 in der Feld-Zwischenebene 18 ist in der Fig. 9 gestrichelt dargestellt. Im Zentrum des Beleuchtungsfelds 35 ist der Intensitätsbeitrag 59 am geringsten. Zum Rand des Beleuchtungsfelds 35 hin steigt der Intensitätsbeitrag 59 kontinuierlich an und erreicht am Rand des Beleuchtungsfelds 35 den höchsten Wert $I_0$.

Die Wirkung einer Transmissionsbeschichtung 60 auf dem zweiten Rasterelement 28 des Kanals III ist in der Fig. 9 durch einen Intensitätsbeitrag 61 über das Beleuchtungsfeld 35 wiedergegeben. Der Intensitätsbeitrag 61 ist in der Fig. 9 strichpunktiert dargestellt. Die Transmissionsbeschichtung 60 des Kanals III hat einen vom Auftreffort auf das zweite Rasterelement 28 des Kanals III abhängigen Effekt, der demjenigen der Transmissionsbeschichtung 56 entspricht. Im Vergleich zur Transmissionsbeschichtung 56 wird bei der Transmissionsbeschichtung 60 der Zentralstrahl des Beleuchtungs-Lichtbündels 26 jedoch nicht so stark geschwächt, sodass die absolute Variation der Intensität beim Intensitätsbeitrag 61 geringer ist. Die Randstrahlen 58 des Kanals III werden wiederum mit einer Intensität $I_0$ durchgelassen.

Die Wirkung einer Transmissionsbeschichtung 62 auf dem zweiten Rasterelement 28 des Kanals II ist in der Fig. 9 durch einen Intensitätsbeitrag 63 über das Beleuchtungsfeld 35 wiedergegeben. Die Transmissionsbeschichtung 62 ist dabei so ausgeführt, dass das Beleuchtungs-Lichtbündel 25 unabhängig von seinem Auftreffort auf die Transmissionsbeschichtung 62 mit gleicher Intensität transmittiert wird. Der Intensitätsbeitrag 63 ist dabei jeweils $I_0$, unabhängig vom Ort auf dem Beleuchtungsfeld 35.

Im Kanal I ist auf dem zweiten Rasterelement 28 wiederum eine Transmissionsbeschichtung 56 entsprechend der Transmissionsbeschichtung 56 des Kanals IV aufgetragen. Das Beleuchtungs-Lichtbündel 24 wird vom Rastermodul 13 nach Fig. 9 genauso beeinflusst wie das Beleuchtungs-Lichtbündel 27, sodass auch das Beleuchtungs-Lichtbündel 24 einen Intensitätsbeitrag entsprechend dem Intensitätsbeitrag 59 über das Beleuchtungsfeld 35 liefert.

Die Unterschiede in der transmissiven Wirkung der Transmissionsbeschichtungen 56, 60 und 62 können durch unterschiedliche Schichtstärken der Transmissionsbeschichtungen oder durch unterschiedliche Materialien, die für diese Transmissionsbeschichtungen eingesetzt werden, erzielt werden. Unterschiede können auch durch unterschiedliche Materialabfolgen der Transmissionsbeschichtungen, die üblicherweise mehrschichtig ausgeführt sind, erreicht werden.

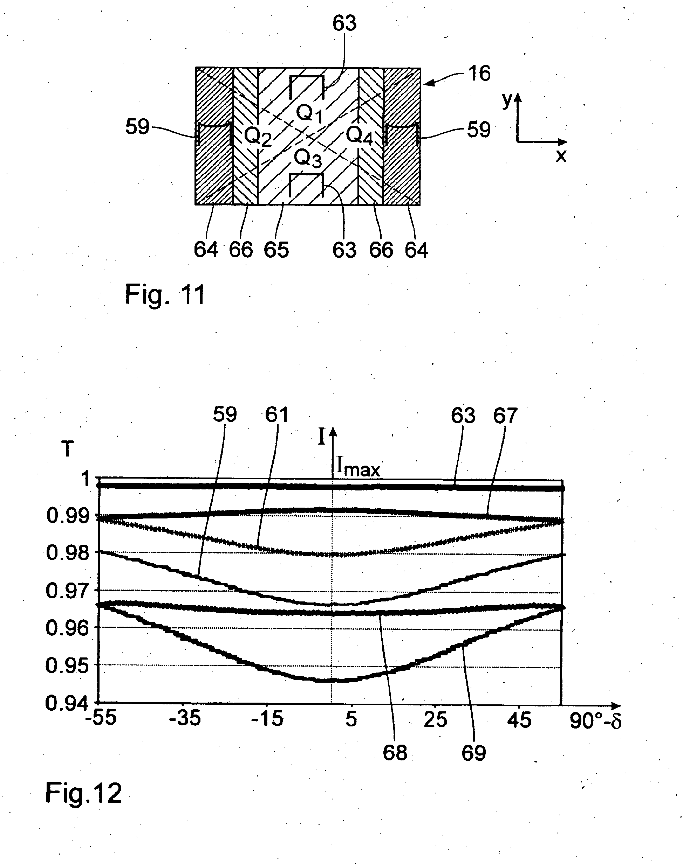

Fig. 11 zeigt schematisch eine Aufsicht auf die zweite Rasteranordnung 16 des Rastermoduls 13 nach Fig. 9 mit einer beispielhaften Verteilung von Rasterelementen 28 mit den Transmissionsbeschichtungen 56, 60, 62. Gegenüberliegende Randstreifen 64 der zweiten Rasteranordnung 16 sind mit zweiten Rasterelementen 28 ausgeführt, die jeweils Transmissionsbeschichtungen mit der optischen Wirkung der Transmissionsbeschichtung 56 der Kanäle I, IV nach Fig. 9 tragen. Jeder der Randstreifen 64 weist dabei eine Mehrzahl von zweiten Rasterelementen 28, also eine Mehrzahl von Kanälen, auf. Die beiden Randstreifen 64 erzeugen über das Beleuchtungsfeld 35 einen Intensitätsbeitrag, der dem Intensitätsbeitrag 59 nach Fig. 9, multipliziert mit der Anzahl der Kanäle in den Randstreifen 64, entspricht, wie in der Fig. 11 angedeutet. Die beiden Randstreifen 64 verlaufen längs einer Scanrichtung y der Projektionsbelichtungsanlage 1.

Ein Zentralstreifen 65, der sich zwischen den beiden Randstreifen 64 erstreckt, weist zweite Rasterelemente 28 auf, deren Transmissionsbeschichtungen die optische Wirkung der Transmissionsbeschichtung 62 des Kanals 11 in Fig. 9 haben. Der Zentralstreifen 65 ist mehr als doppelt so wie breit wie die Randstreifen 64. Der Zentralstreifen 65 trägt mit Intensitätsbeiträgen zur Gesamtintensität im Beleuchtungsfeld 35 bei, die, multipliziert mit der Anzahl der Kanäle im Zentralstreifen 65, dem Intensitätsbeitrag 63 entsprechen, wie in der Fig. 11 angedeutet.

Zwischen dem Zentralstreifen 65 und den beiden Randstreifen 64 ist jeweils noch ein Zwischenstreifen 66 angeordnet. Die Breite der Zwischenstreifen 66, die ebenfalls parallel zur Scanrichtung y verlaufen, ist geringer als die Breite der Randstreifen 64. Die beiden Zwischenstreifen 66 sind mit zweiten Rasterelementen 28 ausgeführt, deren Transmissionsbeschichtungen die optische Wirkung der Transmissionsbeschichtung 60 des Kanals III nach Fig. 9 haben. Die zweiten Rasterelemente 28 der Zwischenstreifen 66 tragen daher zur Intensität über das Beleuchtungsfeld 35 mit Intensitätsbeiträgen 61 bei.

Im Beleuchtungsfeld 35 und nachfolgend im Objektfeld 3 in der Retikelebene 4 führen die randseitigen Beleuchtungs-Lichtbündel, also z. B. die Beleuchtungs-Lichtbündel 24 und 27 nach Fig. 9, zu einer randseitigen Intensitäts-Überhöhung. Hierdurch können Effekte innerhalb des Beleuchtungssystems 5 und/oder innerhalb des Projektionsobjektivs 21 korrigiert oder kompensiert werden.

Fig. 12 zeigt den orts- bzw. auftreffwinkelabhängigen Intensitätsbeitrag für verschiedene Schichtdicken von Transmissionsbeschichtungen der Variationsbeschichtung 55.

Die Transmissionsbeschichtung ist dabei aus einem Material bzw. einer Materialabfolge hergestellt, die bei einer Schichtdicke der Transmissionsbeschichtung von 75 nm einen Intensitätsbeitrag von $I_{max}= 1$ liefert. Eine Transmissionsbeschichtung mit Schichtstärke von 75 nm über das zweite Rasterelement 28 kann also als Transmissionsbeschichtung 62 für den Zentralstreifen 65 herangezogen werden.

Die nachfolgend erläuterten Transmissionsbeschichtungen unterscheiden sich von der soeben erläuterten Transmissionsbeschichtung nur hinsichtlich ihrer Schichtstärke.

Eine Transmissionsbeschichtung mit einer konstanten Schichtstärke von 82 nm führt zu einem Intensitätsbeitrag, der dem Intensitätsbeitrag 61 nach Fig. 9 entspricht. Für den Zentralstrahl 57 ergibt diese 82 nm-Transmissionsbeschichtung eine Transmission von 0,98. Für die Randstrahlen 58 ergibt sich eine Transmission von 0,99. Mit der 82 nm-Beschichtung können die zweiten Rasterelemente 28 der Zwischenstreifen 66 beschichtet sein.

Eine Transmissionsbeschichtung mit einer Schichtstärke von 85 nm führt zu einem Intensitätsbeitrag, der dem Intensitätsbeitrag 59 in der Fig. 9 entspricht. Die Transmission für den Zentralstrahl 57 beträgt etwa 0,967. Die Transmission für die Randstrahlen 58 beträgt etwa 0,98. Diese 85 nm-Transmissionsbeschichtung kann für die beiden Randstreifen 64 herangezogen werden.

Dargestellt sind in der Fig. 12 auch noch andere vielversprechende Schichtstärken-Varianten für Transmissionsbeschichtungen der Variationsbeschichtung 55. Eine Transmissionsbeschichtung mit der Schichtstärke 68 nm hat für den Zentralstrahl 57 eine Transmission von etwa 0,992 und für die Randstrahlen 58 eine Transmission von 0,99 (vgl. Intensitätsbeitrag 67). Hier ist die Transmission für den Zentralstrahl also höher als für die Randstrahlen. Dies kann für eine alternative zweite Rasteranordnung herangezogen werden, bei der in einem Zentralstreifen die Zentralstrahlen im Vergleich zu den Randstrahlen eine höhere Transmission erfahren und in den Randstreifen eine für Rand- und Zentralstrahlen gleichbleibende Transmission oder aber eine Transmission bereitgestellt wird, die für die Zentralstrahlen geringer ist als für die Randstrahlen.

In der Fig. 12 weiterhin dargestellt ist ein Intensitätsbeitrag 68 einer 61 nm-Schicht. Dort ist die Transmission für den Zentralstrahl etwa bei 0,964 und für die Randstrahlen etwa bei 0,966.

Bei einer 89 nm-Schicht ist die Transmission für den Zentralstrahl 57 etwa bei 0,946 und für die Randstrahlen 58 etwa bei 0,966. Eine Kombination aus Schichten mit den Intensitätsbeiträgen 68 und 69 kann daher für ein Rasterelement mit einer dem Rasterelement nach Fig. 11 entsprechenden Wirkung verwendet werden, da sich die Intensitätsbeiträgen 68 und 69 für die Randstrahlen praktisch nicht unterscheiden und den stärksten Unterschied für die Zentralstrahlen haben. Die zweite Rasteranordnung 16 kann beispielsweise im Zentralstreifen 65 mit der 61 nm-Schicht mit dem Intensitätsbeitrag 68 und in den Randstreifen 64 mit 89 nm-Transmissionsbeschichtungen mit den Intensitätsbeiträgen 69 versehen sein.

Anstelle eines Effekts der verschiedenen Transmissionsbeschichtungen 56, 60, 62 der Variationsbeschichtung 55 auf die Transmission kann die Variationsbeschichtung 55 auch mit entsprechend verschiedenen Phasenbeschichtungen versehen sein, die unterschiedliche Beeinflussungen der Phasen der Beleuchtungs-Lichtbündel in den verschiedenen Kanälen des Rastermoduls 13 erzeugen. Unterschiedlich phasenbeeinflussende Beschichtungen können wiederum in Abschnitten z. B. der zweiten Rastanordnung 16 vorgesehen sein, wie am Beispiel der Fig. 11 beschrieben.

Die Variationsbeschichtung 55 kann auch auf der ersten Rasteranordnung 12 angebracht sein. Dabei ist bevorzugt, die Variationsbeschichtung 55 auf der der zweiten Rastanordnung 16 zugewandten Seite der ersten Rasteranordnung aufzubringen. Alternativ ist es möglich, sowohl auf der ersten Rasteranordnung 12 als auch auf der zweiten Rasteranordnung 16 Teilbeschichtungen der Variationsbeschichtung aufzutragen, deren optische Wirkungen sich zur Gesamtwirkung der Variationsbeschichtung 55 ergänzen.

Schließlich ist es möglich, die Variationsbeschichtung 55 nur abschnittsweise auf den Rasteranordnungen 12, 16 des Rastermoduls 13 aufzutragen, um dort eine definierte auftreffortabhängige optische Wirkung zu erzeugen, während in dem nicht beschichteten Abschnitten gerade keine auftreffortabhängige Wirkung resultieren soll.

Anstelle der Unterteilung z. B. der zweiten optischen Rasteranordnung 16 in fünf Streifen 64, 66, 65, 66, 64 mit unterschiedlicher optischer Wirkung kann auch eine andere Unterteilung gewählt werden. Insbesondere kann eine senkrecht zur Scanrichtung y, also in x-Richtung, kontinuierlich variierende optische Wirkung gewählt werden, bei der z. B. die Übergänge zwischen einem Zentralstreifen 65 und benachbarten Streifen hinsichtlich ihrer optischen Wirkung auf die Beleuchtungsintensität über das Beleuchtungsfeld fließend und nicht stufenförmig sind. Auch eine Unterteilung in beispielsweise zwei Streifen, drei Streifen, vier Streifen oder in mehr als fünf Streifen ist möglich. Auch die relative Breite der Streifen zueinander kann unterschiedlich sein. So kann der Zentralstreifen 65 gegenüber den randseitigen Streifen 64, 66 schmäler ausgeführt sein als in Beispiel nach Fig. 11 dargestellt.

Die Beleuchtung jedes Feldpunktes des Beleuchtungsfelds 3, abhängig von der x-Koordinate, kann durch eine charakteristische Größe E(x) beschrieben werden, die eine Maßgröße für die Gleichmäßigkeit der Beleuchtung aus unterschiedlichen Beleuchtungswinkeln darstellt. Diese Größe hängt von den Intensitäten $I_Q$, integriert über vier Quadranten $Q_1$ bis $Q_4$ der zweiten Rasteranordnung 16, ab und ist folgendermaßen definiert:

$$E(x) = ((I_{Q1}(x) + I_{Q3}(x)) / (I_{Q2}(x) + I_{Q4}(x)) - 1) \times 100 \%.$$

Die Größe E(x) wird auch als Elliptizität bezeichnet.

Die vorstehend beschriebene zusätzlich optisch wirkende Einrichtung kann so ausgeführt sein, dass die Elliptizität E(x) in x-Richtung über das Objektfeld 3 um weniger als +/- 1 % variiert.

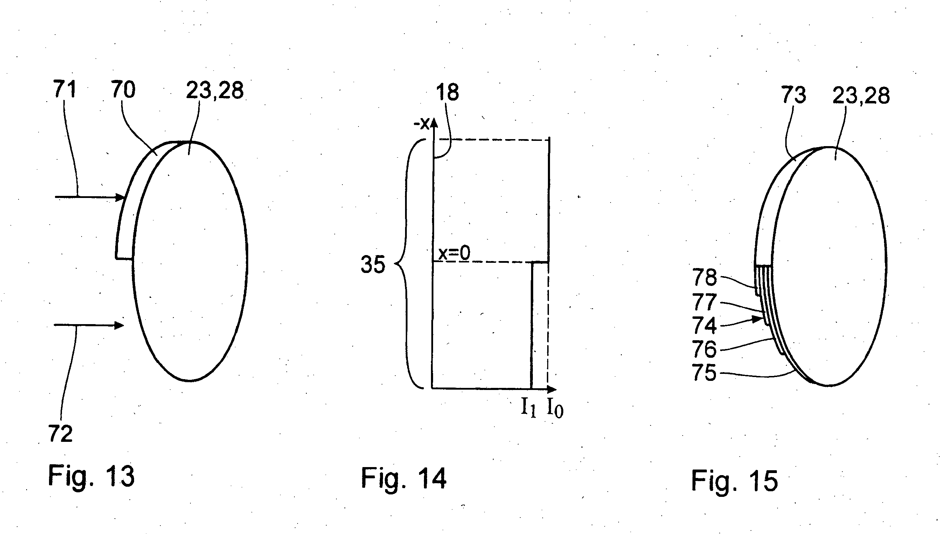

Fig. 13 zeigt eine weitere Ausführung einer Variationsbeschichtung 70 auf einem Rasterelement 23 bzw. 28 des Rastermoduls 13. Die Variationsbeschichtung ist nur auf einer Hälfte der eintrittsseitigen Oberfläche des Rasterelements 23, 28 aufgetragen, sodass ein erster Teilstrahl 71, der auf das Rasterelement 23, 28 auftrifft, die Variationsbeschichtung 70 durchtritt.

Ein zweiter Teilstrahl 72 des Beleuchtungslichtstrahls 8 trifft das Rasterelement 23, 28 hingegen in einem unbeschichteten Bereich der eintrittsseitigen Oberfläche. Die Variationsbeschichtung 70 ist als Antireflexbeschichtung für die Wellenlänge des Beleuchtungslichts 8 ausgeführt. Dementsprechend durchtritt der erste Teilstrahl 71 die Variationsbeschichtung 70 und die nachfolgende Eintrittsfläche des Rasterelements 23, 28 praktisch verlustfrei, wohingegen der zweite Teilstrahl 72 einen Reflexionsverlust von beispielsweise 4 % seiner Lichtleistung erfährt.

Die Wirkung der Variationsbeschichtung 70 über das Beleuchtungsfeld 35 verdeutlicht Fig. 14. Ab der Mitte des Beleuchtungsfeldes 35 (x = 0) in Fig. 14 nach oben hin hat der Beleuchtungslichtstrahl 8 wie der erste Teilstrahl 71 die Variationsbeschichtung 70 passiert, sodass das Beleuchtungsfeld über den Kanal, der dem Rasterelement 23, 28 mit der Variationsbeschichtung 70 zugeordnet ist, mit einer Intensität $I_0$ beleuchtet wird. In der Fig. 14 unterhalb von x = 0 wird das Beleuchtungsfeld 35 über den Kanal des Rasterelements 23, 28 mit der Variationsbeschichtung 70 mit Lichtstrahlen des Beleuchtungslichts 8 beleuchtet, die, da sie den unbeschichteten Abschnitt der eintrittsseitigen Fläche des Rasterelements 23, 28 durchtreten, Reflexionsverluste erleiden. Die in der Fig. 14 untere Hälfte des Beleuchtungsfelds 35 wird daher über diesen Kanal mit einer Intensität $I_1$ beleuchtet, für die näherungsweise gilt: $I_1 = 0,96 \times I_0$. Mit der einfach aufgebauten Variationsbeschichtung 70 lässt sich also eine über das Beleuchtungsfeld 35 variierende Intensitätsverteilung erzeugen. Natürlich kann die Variationsbeschichtung 70 auch austrittsseitig auf den Rasterelementen 23, 28 aufgebracht sein. Zudem können sich ein- und austrittseitige Variationsbeschichtungen nach Art der Variationsbeschichtung 70 in ihrer feldabhängigen Wirkung ergänzen.

Fig. 15 zeigt zwei weitere Varianten von Variationsbeschichtungen. Eine erste dieser Varianten, die Variationsbeschichtung 73, ist in der oberen Hälfte der Fig. 15 auf einem Rasterelement dargestellt. Bei dem Rasterelement kann es sich wiederum um eines der Rasterelemente 23 bzw. 28 handeln. Die Variationsbeschichtung 73 hat eine abhängig vom Auftreffort auf das Rasterelement 23, 28 variierende Schichtdicke. Im Zentrum des Rasterelements 23, 28 ist die Schichtdicke der Variationsbeschichtung 73 am größten. Die Schichtdicke der Variationsbeschichtung 73 fällt zum Rand hin kontinuierlich ab. Entsprechend variiert die Transmission der Variationsbeschichtung 73 für das Beleuchtungslicht 8 vom Zentrum hin zum Rand. Diese Transmission kann vom Zentrum hin zum Rand zu- oder abnehmen. Weiterhin ist es möglich, die Schichtdicke der Variationsbeschichtung 73 so zu gestalten, dass die Variation in einen annularen Abschnitt um das Zentrum des Rasterelements 23, 28 am größten ist, wobei sie einerseits zum Zentrum des Rasterelements 23, 28 hin und andererseits zum Rand des Rasterelements 23, 28 hin kontinuierlich abnimmt. Entsprechend dieser Transmissionsvariation, die durch die Variationsbeschichtung 73 hervorgerufen wird, resultiert eine vom diesem Rasterelement 23, 28 zugeordneten Kanal hervorgerufene feldabhängige Intensitätsvariation entsprechend dem, was vorstehend zum Beispiel in Bezug auf die Fig. 9 erläutert wurde.

Die untere Hälfte der Figur 15 zeigt eine weitere Ausführung einer Variationsbeschichtung 74. Diese hat eine Schichtabfolge, die abhängig vom Auftrittsort des Beleuchtungslichts 8 auf dem Rasterelement 23, 28 variiert. Die Variationsbeschichtung 74 hat eine Schichtabfolge mit einer ersten Grundschicht 75, mit der die gesamte Eintrittsfläche des Rasterelements 23, 28 beschichtet ist. Auf die Grundschicht 75 aufgetragen ist eine erste Zwischenschicht 76, die nicht bis ganz zum Rand des Rasterelements 23, 28 hin ausgeführt ist, sodass ein randseitiger ringförmiger Abschnitt des Rasterelements 23, 28 nur mit der Grundschicht 75 beschichtet ist. Die erste Zwischenschicht 76 trägt eine zweite Zwischenschicht 77, die wiederum nicht bis zum Rand der ersten Zwischenschicht 76 hin ausgeführt ist, sodass jenseits des Randes der zweiten Zwischenschicht 77 ein ringförmiger Abschnitt des Rasterelements 23, 28 vorliegt, der nur mit der Grundschicht und der ersten Zwischenschicht 76 beschichtet ist. Die zweite Zwischenschicht 77 trägt in einem zentralen Abschnitt des Rasterelements 23, 28 eine Deckschicht 78. Diese ist wiederum nicht bis zum Rand der zweiten Zwischenschicht 77 hin ausgeführt, sodass jenseits des Randes der Deckschicht 78 ein ringförmiger Abschnitt des Rasterelements 23, 28 vorliegt, in dem dieser von der Grundschicht 75 sowie der ersten und der zweiten Zwischenschicht 76, 77 beschichtet ist. Die Schichten 75 bis 78 haben die gleiche Schichtstärke. Diese Schichtstärke ist so auf die Wellenlänge des Beleuchtungslichts 8 abgestimmt, dass je nachdem, ob das Beleuchtungslicht 8 eine, zwei, drei öder vier Schichten 75 bis 78 der Variationsbeschichtung 74 durchtreten muss, das Beleuchtungslicht 8 eine unterschiedliche Transmission erfährt. Die Transmission kann beispielsweise im Bereich der Deckschicht 78 am größten sein und stufenweise bis hin zum Bereich der Grundschicht 75 abfallen. Auch ein genau umgekehrter Transmissionsverlauf, der randseitig am größten und im Zentralbereich der Deckschicht 78 am geringsten ist, ist möglich. Schließlich ist auch bei der Variationsbeschichtung 74 ein Transmissionsverlauf möglich, der beispielsweise im Bereich einer der Zwischenschichten 76, 77 die größte Transmission aufweist, wobei die Transmission sowohl zum Rand als auch zum Zentrum des Rasterelements 23, 28 hin abfällt. Die Variationsbeschichtung 74 hat insgesamt vier Einzelschichten 75 bis 78. Auch eine andere Anzahl von Einzelschichten ist möglich. Es können beispielsweise zwei oder drei oder mehr als vier Einzelschichten vorgesehen sein, zum Beispiel 5, 10 oder auch deutlich mehr Einzelschichten wie zum Beispiel 50 oder 100 Einzelschichten. Der randseitige Abschluss der Einzelschichten kann, wie in der Fig. 15 unten dargestellt, stufenförmig sein. Alternativ kann auch ein kontinuierlicher randseitiger Übergang der Einzelschichten hin zur darunter liegenden Trägerschicht vorgesehen sein, was zu einem entsprechenden kontinuierlichen Übergang beim Transmissionsverlauf führt. Je nach der Ausgestaltung der Übergänge kann so ein stufenförmiger Transmissionsverlauf, ein stufenförmiger Transmissionsverlauf mit kontinuierlichen Übergängen oder auch, bei einer entsprechend großen Anzahl von Einzelschichten, ein insgesamt kontinuierlicher Transmissionsverlauf eingestellt werden.

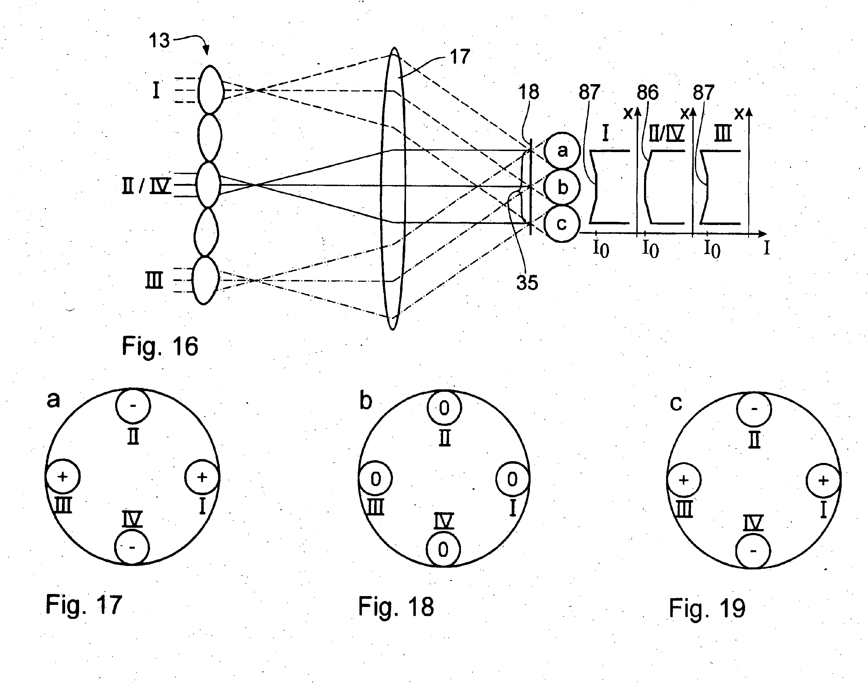

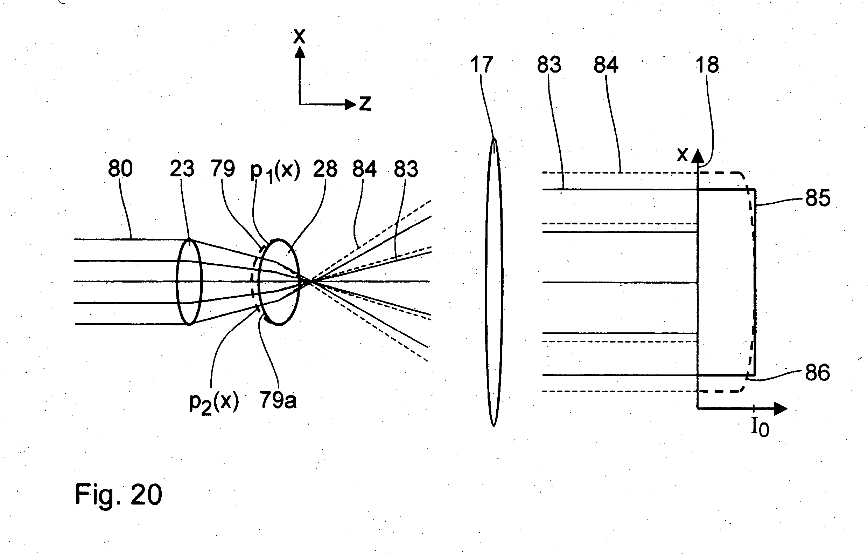

Die Figuren 16 bis 20 zeigen eine weitere nicht erfindungsgemäße Ausführung der zusätzlich optisch wirkenden Einrichtung, in diesem Falle ausgebildet als Formvariation 79 der Eintrittsfläche eines der zweiten Rasterelemente 28, also als Formvariation einer der optisch wirkenden Oberflächen des Rastermoduls 13. Die Formvariation 79 ist in der Fig. 20 gestrichelt als Abweichung von einer Basisform 79a dargestellt. Diese Basisform wird nachfolgend auch als $p_1$ (x) bezeichnet. Die Formvariation 79 wird nachfolgend auch als $p_2$ (x) bezeichnet. Bei dieser Ausführung sind die zweiten Rasterelemente 28 nicht in einer Brennebene der ersten Rasterelemente 23 angeordnet, wie dies beispielsweise bei der Ausführung nach Fig. 4 der Fall ist. Die Brennweite der ersten Rasterelemente 23 ist so auf den Abstand zwischen den ersten Rasterelementen 23 und den zweiten Rasterelementen 28 abgestimmt, dass die zweiten Rasterelemente 28 auf der den ersten Rasterelementen 23 zugewandten Seite der Brennebene angeordnet sind. Dies bedingt, dass ein Beleuchtungs-Lichtbündel 80, welches den von den in der Fig. 20 dargestellten Rasterelementen 23, 28 vorgegebenen Kanal beauf schlagt, die die Formvariation 79 aufweisende Oberfläche des Rasterelements 28 als räumlich ausgedehntes Lichtbündel beaufschlagt.

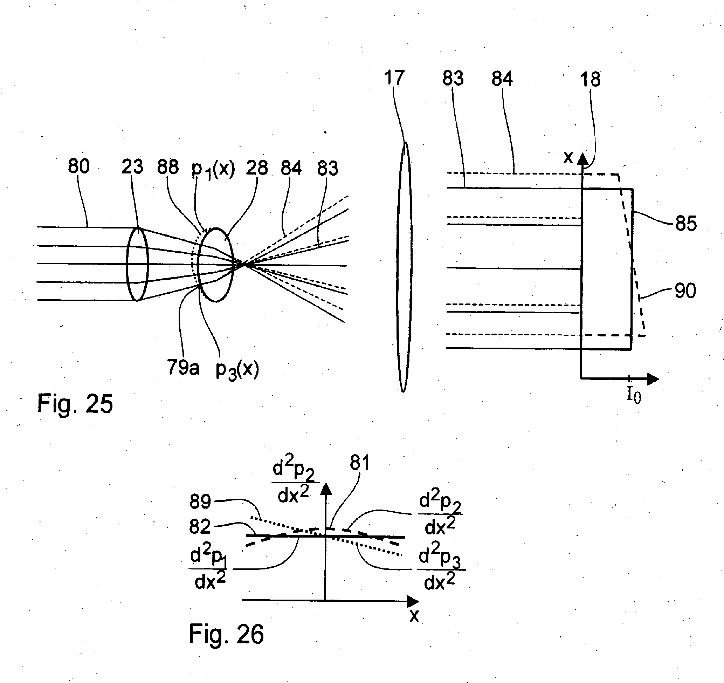

Die Formvariation 79 ist abhängig vom Auftreffort des Beleuchtungs-Lichtbündels 80 auf dem Rasterelement 28 so ausgeführt, dass die zweite Ableitung der Formvariation 79 über die Ortskoordinaten x und y eine gerade Funktion ergibt. Dies wird am Beispiel der Ortkoordinate x anhand der Fig. 26 verdeutlicht, die gestrichelt eine derartige zweite Ableitung 81 der Formvariation 79 als gerade Funktion wiedergibt. Im Vergleich hierzu ist die zweite Ableitung 82 der Basisform 79a angegeben, die konstant ist. Diese Ausgestaltung der Formvariation 79 mit zweiter Ableitung 81 führt dazu, dass das Beleuchtungs-Lichtbündel 80 durch die kombinierte Wirkung des ersten Rasterelements 23 und des zweiten Rasterelements 28 randseitig stärker aufgefächert wird als im Bereich des Zentrums des Beleuchtungs-Lichtbündels 80.

Dies ist in der Fig. 20 anhand eines Vergleichs durchgezogener Strahlen 83 des Beleuchtungs-Lichtbündels 80, die das Rastermodul ohne Formvariation 79, d. h. mit der Basisform 79a durchtreten, mit gestrichelt dargestellten Strahlen 84 deutlich, die das Rastermodul mit der Formvariation 79 durchtreten. Die Strahlen 83 werden gleichmäßig aufgefächert, sodass der Winkel zwischen äquidistant benachbart in das Rastermodul einfallender Strahlen immer der gleiche ist. Dies führt zu einem konstanten Intensitätsbeitrag 85 eines Kanals mit der Basisform 79a, wie in der Fig. 20 rechts dargestellt.

Beim Kanal mit der Formvariation 79 werden die randseitigen Strahlen 84 stärker aufgefächert, sodass das Beleuchtungs-Lichtbündel 80, über seinen Querschnitt nach der Brennebene nach dem zweiten Rasterelement 28 gesehen, randseitig weniger Energie bzw. Intensität transportiert als in seinem zentralen Bereich. Dies äußert sich durch einen in der Fig. 20 rechts gestrichelt dargestellten Intensitätsbeitrag 86, der einen angenähert parabolischen Verlauf aufweist, wobei die Intensität des Intensitätsbeitrags 86 im Zentrum des Beleuchtungsfeldes 35 am größten ist und zum Rand hin kontinuierlich abfällt. Der Intensitätsbeitrag 86 entspricht somit qualitativ dem Intensitätsbeitrag 67 nach Fig. 12.

Dieser qualitative Verlauf ist auch schematisch in der Fig. 16 dargestellt und den Kanälen II und IV zugeordnet. In der Darstellung nach Fig. 16 ist dieser parabolische Verlauf durch eine abknickende Funktion angenähert.

Die zweite Ableitung 81 kann, immer noch als gerade Funktion, so abgewandelt werden, dass die auffächernde Wirkung der Formvariation 79 im Zentrum des Beleuchtungs-Lichtbündels 80 am stärksten ist und zum Rand hin abnimmt. Bei einer derartigen Ausgestaltung der Formvariation 79 transportiert das Beleuchtungs-Lichtbündel 80, gesehen über seinen Querschnitt, im Zentrum mehr Energie als randseitig. Ein entsprechender Intensitätsbeitrag 87 ist in der Fig. 16 dargestellt und den Kanälen I und III zugeordnet.

Die Kanäle I bis IV sind in Bezug auf den einfallenden Beleuchtungslichtstrahl 8 in den vier Ecken eines Quadrats angeordnet.

Der Beleuchtungseffekt, der sich in der Feld-Zwischenebene 18 bei der Ausgestaltung des Rastermoduls 13 mit den Formvariationen 79 gemäß Fig. 16 einstellt, ist für drei verschiedene Orte bzw. Feldpunkte a, b, c in den Fig. 17 bis 19 dargestellt.

Fig. 17 zeigt die Situation im Feldpunkt a, der im Beleuchtungsfeld 35 in der Darstellung nach Fig. 16 oben und in hierzu senkrechter y-Richtung in etwa mittig im Beleuchtungsfeld 35 angeordnet ist. Dieser Feldpunkt a sieht aus Richtung der Kanäle I und III eine erhöhte Intensität und aus Richtung der Kanäle II und IV eine gegenüber dem Basis-Intensitätsbeitrag 85 verringerte Intensität. Die Abweichungen vom Basis-Intensitätsbeitrag $I_0$ sind in der Fig. 17 durch "+" für eine positive Abweichung und durch "-" für eine negative Abweichung symbolisiert. Entsprechend sieht der Feldpunkt a eine Beleuchtung mit einer gezielt von 1 abweichenden Elliptizität. Unter der Annahme, dass die Intensität der Kanäle I und III 1,03 $I_0$ und die Intensität der Kanäle II und IV 0,97 $I_0$ beträgt, ergibt sich eine Elliptizität E (a) von 6,2 %. Hieraus wird deutlich, dass durch die Formvariation 79 erhebliche Elliptizitätskompensationen oder Elliptizitätseinstellungen nach Vorgabewerten möglich sind.

Der Feldpunkt a sieht demnach eine intensitätsabhängige Beleuchtungswinkelverteilung in Form eines schwach ausgebildeten y-Dipols. Der Feldpunkt b sieht aus den Richtungen aller Kanäle I bis IV die gleiche Intensität $I_0$.

Der Feldpunkt c sieht die gleiche intensitätsabhängige Beleuchtungswinkelverteilung wie der Feldpunkt a.

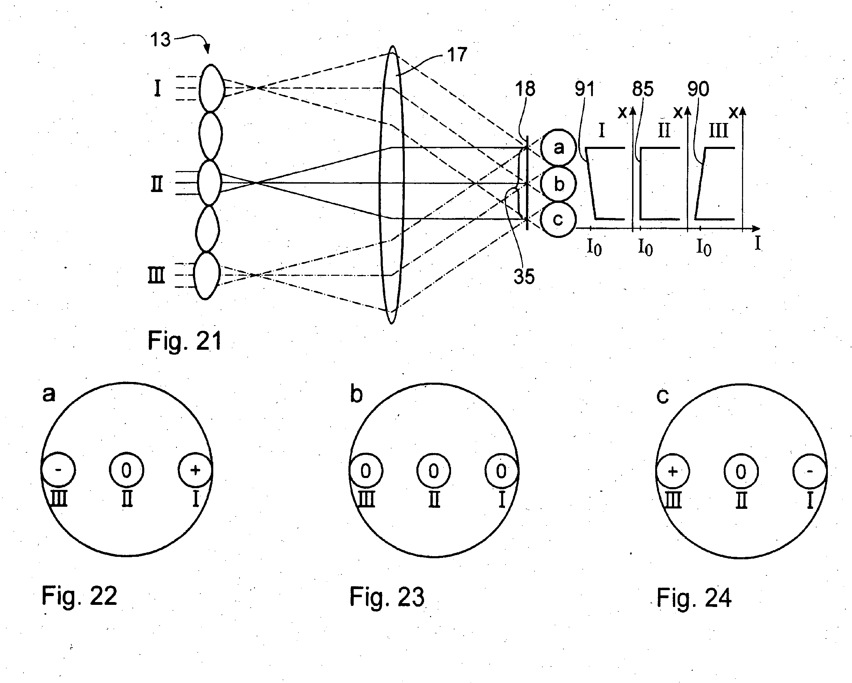

Die Fig. 21 bis 25 zeigen schematisch die optische Wirkung eines weiteren Rastermoduls mit einer weiteren Ausführung einer Formvariation 88, die links in der Fig. 25 auf der Eintrittsseite des zweiten Rasterelements 28 dargestellt ist. Die Formvariation 88 wird nachfolgend auch als $p_3(x)$ bezeichnet. Komponenten sowie Bezugsgrößen, die vorstehend schon unter Bezugnahme auf die Fig. 16 bis 20 sowie 26 erläutert wurden, tragen die gleichen Bezugsziffern und werden nicht nochmals im Einzelnen diskutiert.

Die Formvariation 88 hat eine zweite Ableitung 89 in Form einer Funktion mit ungeradem Anteil. Die zweite Ableitung 89 ist gepunktet in der Fig. 26 dargestellt. Diese ungerade zweite Ableitung 89 führt bei der Formvariation 88 dazu, dass das Beleuchtungs-Lichtbündel 80 in einem in der Figur 25 oben dargestellten Bündelbereich stärker aufgefächert wird als im unten dargestellten Bündelbereich, wie sich durch einen Vergleich der Strahlen 83 ohne Formvariation 88 mit den Strahlen 84 mit Formvariation 88 nachvollziehen lässt. Diese in x-Richtung ungerade Auffächerungswirkung führt zu einem gekippten Intensitätsbeitrag 90 im Beleuchtungsfeld 35, der zum Beispiel dem Intensitätsbeitrag 38 bei der Ausführung nach Fig. 2 entspricht.

Die Fig. 21 bis 24 verdeutlichen die feldabhängige Wirkung des Rastermoduls 13 mit zweiten Rasterelementen 28 mit der Formvariation 88. Die Kanäle I bis III sind bei der Anordnung nach Figur 21 auf einer Höhe (y = konstant) angeordnet.

Die Formvariationen 88 der Kanäle I und III sind genau spiegelsymmetrisch zueinander in Bezug auf eine den Zentralstrahl des Beleuchtungslichtstrahls 8 enthaltenden yz-Ebene angeordnet. Die optische Wirkung der Formvariation 88 des Kanals III führt dabei zum Intensitätsbeitrag 90, wie auch in der Fig. 25 dargestellt. Die hierzu spiegelsymmetrische Ausgestaltung der Formvariation 88 des Kanals I führt zu einem entsprechend spiegelsymmetrischen Intensitätsbeitrag 91 des Kanals I. Der Kanal II ist ohne Formvariation ausgeführt, sodass hier der Basis-Intensitätsbeitrag 85 resultiert.

Die feldabhängige Beleuchtungswinkelverteilung der Anordnung nach Fig. 21 ist in den Fig. 22 bis 24 dargestellt. Beim in der Fig. 21 obersten Feldpunkt a trägt der Kanal I mit gegenüber $I_0$ vergrößerter Intensität und der Kanal III mit gegenüber $I_0$ kleinerer Intensität bei. Dies wird entsprechend durch "+" beim Kanal I und "-" beim Kanal III verdeutlicht. Der Kanal II liefert bei allen Feldpunkten a, b, c den Intensitätsbeitrag $I_0$, in den Fig. 22 bis 24 verdeutlicht durch "0". Beim Feldpunkt b tragen alle Kanäle I bis III mit dem Intensitätsbeitrag $I_0$ bei. Im Feldpunkt c trägt der Kanal I mit gegenüber $I_0$ geringerer Intensität und der Kanal III mit gegenüber $I_0$ vergrößerter Intensität bei.

Die in x-Richtung randseitigen Feldpunkte erfahren also aus den den Rand der Beleuchtungsoptik durchlaufenden Beleuchtungsrichtungen die größte Intensität. Dies kann zu Kompensationszwecken herangezogen werden, wenn die Beleuchtungsoptik randseitig eine etwas geringere Transmission aufweist als über den Rest der Apertur der Beleuchtungsoptik.

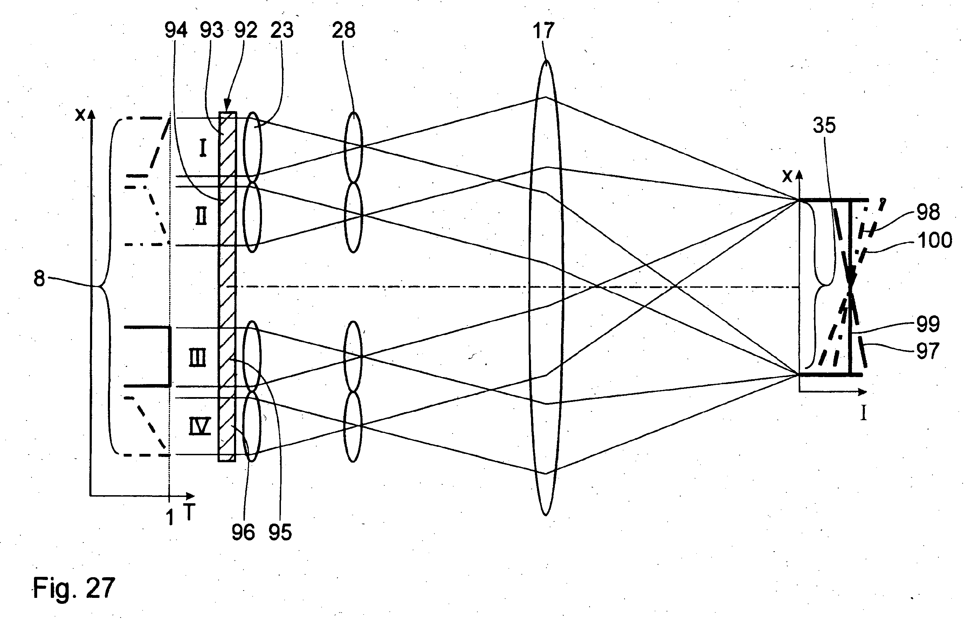

Fig. 27 zeigt eine nicht erfindungsgemäße Ausgestaltung der zusätzlich optisch wirkenden Einrichtung als Intensitäts-Variationseinrichtung 92. Letztere hat Variations-Filterelemente 93, 94, 95, 96, die den ersten Rasterelementen 23 der ersten Rasteranordnung 12 zugeordnet sind. Das Variations-Filterelement 93 ist dabei einem Kanal I, das Variations-Filterelement 94 einem Kanal II, das Variations-Filterelement 95 einem Kanal III und das Variations-Filterelement 96 einem Kanal IV des Beleuchtungslichtstrahls 8 zugeordnet. Die Variations-Filterelemente 93 bis 96 wirken derart, dass das Beleuchtungslicht 8, das nach dem Durchtreten der Variations-Filterelemente 93 bis 96 auf die zugeordneten Rasterelemente 23 trifft, eine vom Auftreffort auf diese Rasterelemente 23 abhängige Abschwächung erfährt.

Die Variations-Filterelemente 93 bis 96 sind als Reflexions-Filterelemente ausgeführt und haben einen für das Beleuchtungslicht 8 transparenten Träger, in dem für das Beleuchtungslicht reflektierende Partikel eingelagert sind. Bei den Partikeln handelt es sich um Metallpartikel, im Beispiel nach Figur 27 um Chrompartikel. Diese haben vorzugsweise einen Mindestdurchmesser von 50 μm. Vorzugsweise gilt, dass der Mindestdurchmesser der Partikel größer ist als das 250-fache der Wellenlänge des Beleuchtungslichts.

Die Vorgabe des auftreffortabhängigen Transmissionsverlaufs der Variations-Elemente 93 bis 96 geschieht über eine Vorgabe der Häufigkeit der Chrompartikel pro Volumeneinheit des Trägermaterials. Alternativ oder zusätzlich ist es möglich, den Transmissionsverlauf über Auftreffflächen der Variations-Filterelemente 93 bis 96 über die Partikelgröße vorzugeben. Je größer eines der Partikel ist, desto stärker ist seine reflektierende Wirkung. Die Auftreffflächen sind die jeweils den Kanälen I bis IV zugeordneten Oberflächenbereiche der Variations-Filterelemente 93 bis 96.

Das Variations-Filterelement 93 hat eine auftreffortabhängig derartige Reflexionswirkung, dass der Kanal I im Beleuchtungsfeld 35 einen Intensitätsbeitrag 97 liefert, der dem Intensitätsbeitrag 38 der Ausführung nach Fig. 2 qualitativ entspricht. Dies wird erreicht, indem beim Variations-Filterelement 93 am in der Fig. 27 oberen Rand Chrompartikel zunehmend dichter angeordnet sind oder indem nach oben hin Chrompartikel zunehmender Größe in den Träger eingelagert werden.

Das Variations-Filterelement 94 im Kanal II hat eine zur yz-Ebene genau spiegelsymmetrische Anordnung der Chrompartikel im Vergleich zur Anordnung im Variations-Filterelement 93. Dies führt zu einem Intensitätsbeitrag 98 des Kanals II über das Beleuchtungsfeld 35, der dem Intensitätsbeitrag 37 nach Fig. 2 entspricht.

Das Variations-Filterelement 95 liefert eine über den Auftreffort konstante Transmission, sodass ein konstanter Basis-Intensitätsbeitrag 99 resultiert. Das Variations-Filterelement 96 liefert einen Intensitätsbeitrag 100, dessen qualitativer Verlauf mit dem des Intensitätsbeitrags 98 übereinstimmt, wobei der Intensitätsbeitrag 100 eine größere absolute Steigung dI/dx aufweist.

Hinsichtlich der feldabhängigen Wirkung auf die Intensitätsbeiträge ist die Anordnung nach Fig. 27 mit derjenigen nach Fig. 2 vergleichbar.

Die x-abhängigen Transmissionsverläufe T(x) der Variations-Filterelemente 93 bis 96 sind in der Fig. 27 jeweils links neben den Variations-Filterelementen 93 bis 96 schematisch dargestellt. In y-Richtung können die Variations-Filterelemente eine entsprechende Abhängigkeit der Transmissionsverläufe aufweisen. Alternativ ist es möglich, dass die Variations-Filterelemente 93 bis 96 in y-Richtung eine qualitativ andere Abhängigkeit des Transmissionsverlaufs oder aber eine in y-Richtung konstante Transmission aufweisen.

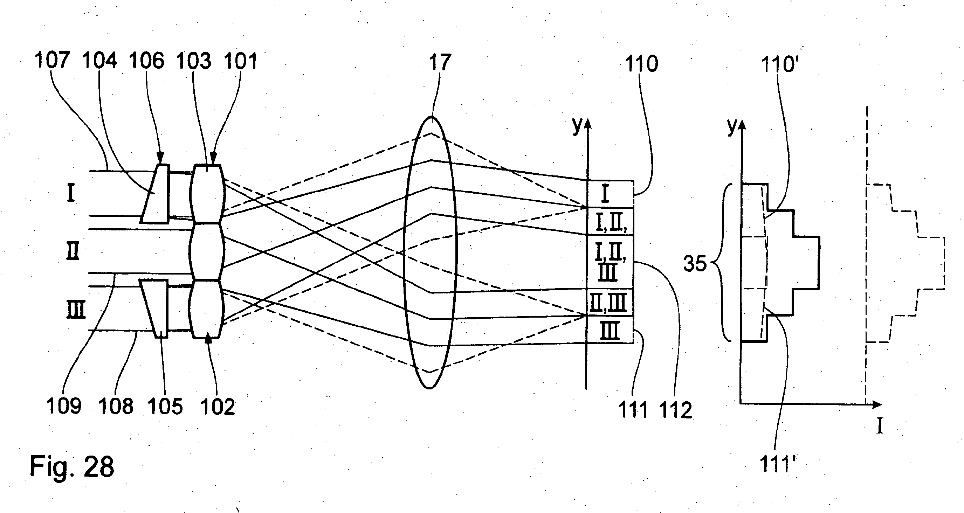

Fig. 28 zeigt eine Variante eines Rastermoduls 101, welches anstelle zweier Rasteranordnungen nur eine einzige Rasteranordnung 102 mit Rasterelementen 103 aufweist. Der Aufbau der Rasteranordnung 102 entspricht demjenigen der ersten Rasteranordnung 12 der vorstehend beschriebenen Ausführungsbeispiele. Die Rasteranordnung 102 ist in einer oder benachbart zu einer Pupillenebene des Beleuchtungssystems nach Fig. 28 angeordnet. Auch die nachgelagerten Komponenten des Beleuchtungssystems bei der Ausführung nach Fig. 28 entsprechen denen der vorstehend diskutierten Ausführungsbeispiele. Dargestellt sind in der Fig. 28 drei Kanäle I, II, III, in die der Beleuchtungslichtstrahl 3 aufgeteilt ist. Auch die Ausführung nach Fig. 28 kann eine viel größere Anzahl an Rasterkanälen aufweisen, wie dies auch für die vorstehend beschriebenen Ausführungsbeispiele gilt.

Vor den Rasterelementen 103 der Kanäle I und III ist jeweils ein Winkelvariationsabschnitt 104, 105 einer Beleuchtungswinkel-Variationseinrichtung 106 angeordnet. Die Winkelvariationsabschnitte 104, 105 sind als Keilplatten ausgeführt, die die den Kanälen I und III zugeordneten Beleuchtungs-Lichtbündel 107, 108 auf das dem Kanal II zugeordnete Beleuchtungs-Lichtbündel 109 zu ablenken. Durch die optische Wirkung des Rastermodul 101 und des Kondensors 17 führt diese Ablenkung durch die Winkelvariationsabschnitte 104, 105 dazu, dass die Intensitätsbeiträge 110, 111 für Kanäle I und III gegenüber einem Intensitätsbeitrag 112 des Kanals II in positive bzw. negative y-Richtung versetzt sind. Die Größe des Versatzes hängt ab von der abbildenden Wirkung der Winkelvariationsabschnitte 104, 105 und von deren Abstand zur Rasteranordnung 102. In der Fig. 28 ist rechts die Summe der Intensitätsbeiträge 110 bis 112 dargestellt. Es ergibt sich eine Treppenfunktion. Die Anzahl der Stufen hängt ab von der Anzahl der beteiligten Rasterelemente 103. Durch den Einsatz einer größeren Anzahl von Winkelvariationsabschnitten mit unterschiedlichen Ablenkwinkeln kann auch anstelle der Treppenfunktion eine Trapezfunktion erreicht werden.

Im Intensitätsdiagramm, welches in der Fig. 28 rechts dargestellt ist, ist durchgezogen eine Gesamtintensität dargestellt, die sich ergibt, wenn die Winkelvariationsabschnitte 104, 105 nicht zu einer auftreffortabhängigen optischen Wirkung führen. Wenn die Winkelvariationsabschnitte 104, 105 zusätzlich eine auftreffortabhängige Wirkung haben, wie dies im Zusammenhang zum Beispiel mit der Figur 4 vorstehend diskutiert wurde, resultieren gekippte Intensitätsbeiträge 110', 111', die innerhalb der durchgezogenen Treppenfunktion in der Fig. 28 rechts dargestellt sind. In Fig. 28 ganz rechts ist dann entsprechend die Summe der beiden gekippten Intensitätsbeiträge 110', 111' mit dem Intensitätsbeitrag 112 dargestellt.

Die vorstehend erläuterten, verschiedenen Ausgestaltungen von zusätzlich optisch wirkenden Einrichtungen können, soweit sie einzelnen Rasterelementen 23, 28 1:1 zugeordnet sind, für einzelne Rasterelemente 23, 28, für eine Mehrzahl von Rasterelementen 23, 28, insbesondere in zusammenhängenden Bereichen des Rastermoduls 13, oder für alle Rasterelemente 23, 28 vorgesehen sein.

Die optisch wirkenden Oberflächen der Rasterelemente 28 mit der jeweiligen Formvariation 79, 88 können insbesondere als Freiformflächen ausgebildet sein. Die Freiformflächen sind insbesondere so ausgeführt, dass sie nicht durch eine rotationssymmetrische Funktion, also durch eine sphärische Funktion oder eine Asphärenfunktion, beschrieben werden, sondern rotationssymmetrisch sind.

**Patentansprüche**

1. Beleuchtungssystem (5) für die Mikro-Lithographie zur Beleuchtung eines Beleuchtungsfeldes (3) mit Beleuchtungslicht (8) einer primären Lichtquelle (6)

   - mit einer ersten Rasteranordnung (12; 102) mit ersten, in ersten Rasterzeilen und ersten Rasterspalten angeordneten Rasterelementen (23), die in einer ersten Ebene (11) oder benachbart zu dieser angeordnet ist, zur Erzeugung einer Rasteranordnung sekundärer Lichtquellen,
   - mit einer Übertragungsoptik (17, 19, 20) zur überlagernden Übertragung des Beleuchtungslichts (8) der sekundären Lichtquellen in das Beleuchtungsfeld (3),
   - mit einer Lichtverteilungseinrichtung (9, 10) zur Erzeugung einer vorgegebenen zweidimensionalen Intensitätsverteilung aus dem Beleuchtungslicht (8) in der ersten Ebene (11) senkrecht zu einer optischen Achse (2) des Beleuchtungssystems (5),

   wobei

- der ersten Rasteranordnung (12; 102) eine zusätzlich optisch wirkende Einrichtung (14; 55; 70; 79; 88; 92; 106) räumlich benachbart zugeordnet ist oder in einer Ebene angeordnet ist, die zu einer Ebene optisch konjugiert ist, in der die erste Rasteranordnung (12; 102) angeordnet ist,

- wobei die zusätzlich optisch wirkende Einrichtung (14; 55; 70; 79; 88; 92; 106) eine Eigenschaft des Beleuchtungslichts (8) aus folgender Gruppe beeinflusst:

-- Intensität,
-- Phase,
-- Strahlrichtung,

- **gekennzeichnet durch** eine im Lichtweg benachbart zur ersten Rasteranordnung (12) oder in einer Ebene, die zu einer Ebene optisch konjugiert ist, in der die erste Rasteranordnung (12) angeordnet ist, angeordneten Beleuchtungswinkel-Variationseinrichtung (14; 40; 47) als die zusätzlich optisch wirkende Einrichtung,

-- welche Beleuchtungslicht (8), das auf die Beleuchtungswinkel-Variationseinrichtung (14; 40; 47) trifft, in mindestens zwei Winkelvariationsabschnitten (30-33; 42, 43; 50, 51) senkrecht zur optischen Achse (2) mit unterschiedlichen Ablenkwinkeln ($\alpha$', $\gamma$') ablenkt,
-- wobei ein von der Beleuchtungswinkel-Variationseinrichtung (14; 40; 47) erzeugter maximaler Ablenkwinkel ($\alpha$', $\gamma$') so groß ist, dass ein Intensitätsbeitrag (36-38; 44, 45; 54) von Rasterelementen (23) der ersten Rasteranordnung (12) zur Gesamt-Beleuchtungsintensität (39; 46; 54) über das Beleuchtungsfeld (3) variiert.

2. Beleuchtungssystem nach Anspruch 1, **gekennzeichnet durch** eine im Beleuchtungs-Lichtweg nach der ersten Rasteranordnung (12) angeordnete zweite Rasteranordnung (16) mit zweiten Rasterelementen (28), die zusammen mit der ersten Rasteranordnung (12) ein Rastermodul (13) bildet.

3. Beleuchtungssystem nach einem der Ansprüche 1 bis 2, **gekennzeichnet durch** eine Ausgestaltung der zusätzlich optisch wirkenden Einrichtung (14) derart, dass im Bereich der ersten Rasteranordnung (12) eine Beeinflussung der Eigenschaft des Beleuchtungslichts (8) eingestellt ist, die von der Übertragungsoptik (17) in eine beleuchtungsfeldabhängige Gesamt-Intensitätsverteilung (39) umgesetzt wird, wobei unterschiedliche Beleuchtungsfeldpunkte mit unterschiedlichen Intensitätsbeiträgen (34, 36-38) aus den möglichen Beleuchtungsrichtungen (I-IV) beleuchtet werden.

4. Beleuchtungssystem nach einem der Ansprüche 1 bis 2, **gekennzeichnet durch** eine Ausgestaltung der zusätzlich optisch wirkenden Einrichtung (47) derart, dass im Bereich der ersten Rasteranordnung (12) eine Beeinflussung der Eigenschaft des Beleuchtungslichts (8) eingestellt ist, die von der Übertragungsoptik (17) in eine beleuchtungsfeldabhängige Gesamt-Intensitätsverteilung (54) umgesetzt wird, wobei unterschiedliche Beleuchtungsfeldpunkte mit gleichen Intensitäten (54) aus den möglichen Beleuchtungsrichtungen (I-IV) beleuchtet werden.

5. Beleuchtungssystem nach einem der Ansprüche 1 bis 2, **gekennzeichnet durch** eine Ausgestaltung der zusätzlich optisch wirkenden Einrichtung (40) derart, dass im Bereich der ersten Rasteranordnung (12) eine Eigenschaft des Beleuchtungslichts (8) eingestellt ist, die von der Übertragungsoptik (17) in eine beleuchtungsfeldunabhängige Gesamt-Intensitätsverteilung (46) umgesetzt wird, wobei unterschiedliche Beleuchtungsfeldpunkte mit unterschiedlichen Intensitätsbeiträgen (44, 45) aus den möglichen Beleuchtungsrichtungen (I-IV) beleuchtet werden.

6. Beleuchtungssystem nach einem der Ansprüche 1 bis 5, **gekennzeichnet durch** eine Unterteilung der Beleuchtungswinkel-Variationseinrichtung (14; 40; 47) in mindestens zwei Winkelvariationsabschnitte (30, 33; 42, 43; 50,51), zwischen denen sich der erzeugte Ablenkwinkel ($\alpha$', $\gamma$') unterscheidet.

7. Beleuchtungssystem nach Anspruch 6, **gekennzeichnet durch** eine Unterteilung der Beleuchtungswinkel-Variationseinrichtung (14) in mindestens vier Winkelvariationsabschnitte (30-33), zwischen denen sich der erzeugte Ablenkwinkel jeweils unterscheidet.

8. Beleuchtungssystem nach einem der Ansprüche 1 bis 7, **dadurch gekennzeichnet, dass** die zusätzlich optisch wirkende Einrichtung (14; 40; 47) diffraktiv ausgeführt ist.

9. Beleuchtungssystem nach einem der Ansprüche 1 bis 7, **dadurch gekennzeichnet, dass** die zusätzlich optisch wirkende Einrichtung (14; 40; 47) refraktiv ausgeführt ist.

10. Beleuchtungssystem nach einem der Ansprüche 1 bis 9, **dadurch gekennzeichnet, dass** die Beleuchtungswinkel-Variationseinrichtung (40; 47) mindestens ein Dachkanten-Prisma (40; 48) aufweist.

11. Mikrolithographie-Projektionsbelichtungsanlage (1) mit einem Beleuchtungssystem (5) nach einem der Ansprüche 1 bis 10.

12. Verfahren zur mikrolithographischen Herstellung mikrostrukturierter Bauelemente mit folgenden Schritten:

- Bereitstellen eines Substrats, auf das zumindest teilweise eine Schicht aus einem lichtempfindlichen Material aufgebracht ist,
- Bereitstellen eines Retikels, das abzubildende Strukturen aufweist,
- Bereitstellen einer Projektionsbelichtungsanlage (1) nach Anspruch 11,
- Projizieren wenigstens eines Teils des Retikels auf einen Bereich der Schicht mit Hilfe der Projektionsbelichtungsanlage (1).

**Claims**

1. Microlithographic illumination system (5) for illumination of an illumination field (3) with illumination light (8) of a primary light source (6), the illumination system (5) comprising

- a first raster array (12; 102) comprising first raster elements (23) arranged in first raster lines and first raster columns, said first raster array (12; 102) being disposed in a first plane (11) or adjacent thereto for generation of a raster array of secondary light sources;
- a transmission optics (17, 19, 20) for superimposing guidance of the illumination light (8) of the secondary light sources into the illumination field (3);
- a light distribution device (9, 10) for generating, from the illumination light (8), a defined two-dimensional intensity distribution in the first plane (11) which is perpendicular to an optical axis (2) of the illumination system (5);

wherein

- a device (14; 55; 70; 79; 88; 92; 106) with an additional optical effect is disposed spatially adjacent to the first raster array (12; 102) or is disposed in a plane which is optically conjugated with a plane in which the first raster array (12; 102) is disposed;
- wherein the device (14; 55; 70; 79; 88; 92; 106) with the additional optical effect influences a property of the illumination light (8), wherein said property is included in the following group:

-- intensity;
-- phase;
-- beam direction,
**characterized by**

- an illumination angle variation device (14; 40; 47), serving as the device with the additional optical effect, which is disposed in the light path adjacent to the first raster array (12) or in a plane which is optically conjugated with a plane in which the first raster array (12) is disposed, said device (14; 40; 47)

-- deflecting illumination light (8) hitting the illumination angle variation device (14; 40; 47) in at least two angle variation portions (30-33; 42, 43; 50, 51) which have different deflection angles ($\alpha$', $\gamma$') perpendicular to the optical axis (2);
-- wherein a maximum deflection angle ($\alpha$', $\gamma$') generated by the illumination angle variation device (14; 40; 47) has such a size that an intensity contribution (36-38; 44, 45; 54) of raster elements (23) of the first raster array (12) to the total illumination intensity (39; 46; 54) varies across the illumination field (3).

2. Illumination system according to claim 1, **characterized by** a second raster array (16) which is disposed in the illumination light path downstream of the first raster array (12), the second raster array (16) comprising second raster elements (28) and forming a raster module (13) together with the first raster array (12).

3. Illumination system according to one of claims 1 to 2, **characterized by** a design of the device (14) with the additional optical effect such that an influence of the property of the illumination light (8) is set in the vicinity of the first raster array (12), said influence being transformed into an illumination-field-dependent total intensity distribution (39) by the transmission optics (17), wherein different illumination field points are exposed to different intensity contributions (34, 36-38) from the possible directions of illumination (I-IV).

4. Illumination system according to one of claims 1 to 2, **characterized by** a design of the device (47) with the additional optical effect such that an influence of the property of the illumination light (8) is set in the vicinity of the first raster array (12), said influence being transformed into an illumination-field-dependent total intensity distribution (54) by the transmission optics (17), wherein different illumination field points are exposed to equal intensities (54) from the possible directions of illumination (I-IV).

5. Illumination system according to one of claims 1 to 2, **characterized by** a design of the device (40) with the additional optical effect such that an influence of the property of the illumination light (8) is set in the area of the first raster array (12), said influence being transformed into an illumination-field-independent total intensity distribution (46) by the transmission optics (17), wherein different illumination field points are exposed to different intensities contributions (44, 45) from the possible directions of illumination (I-IV).

6. Illumination system according to one of claims 1 to 5, **characterized by** a division of the illumination angle variation device (14; 40; 47) into at least two angle variation portions (30, 33; 42, 43; 50, 51) between which the generated deflection angle ($\alpha$', $\gamma$') differs.

7. Illumination system according to claim 6, **characterized by** a division of the illumination angle variation device (14) into at least four angle variation portions (30-33) between which the respective generated deflection angle differs.

8. Illumination system according to one of claims 1 to 7, **characterized in that** the device (14; 40; 47) with the additional optical effect is diffractive.

9. Illumination system according to one of claims 1 to 7, **characterized in that** the device (14; 40; 47) with the additional optical effect is refractive.

10. Illumination system according to one of claims 1 to 9, **characterized in that** the illumination angle variation device (40; 47) has at least one roof-edge prism (40; 48).

11. Microlithographic projection exposure apparatus (1) comprising an illumination system (5) according to one of claims 1 to 10.

12. Method for microlithographic fabrication of microstructured components, the method comprising the following steps:

- provision of a substrate onto which a coating of a light-sensitive material is applied to at least part;
- provision of a reticle which has structures to be imaged;
- provision of a projection exposure apparatus (1) according to claim 11;
- projection of at least a part of the reticle onto an area of the coating by means of the projection exposure apparatus (1).

**Revendications**

1. Système d'éclairage (5) pour la micro lithographie destiné à l'éclairage d'un champ d'éclairage (3) avec une lumière d'éclairage (8) d'une source lumineuse primaire (6)

- comprenant un premier arrangement de trame (12 ; 102) comportant les premiers éléments de trame (23), disposés dans les premières lignes de trame et les premières fentes de trame, qui sont disposées dans un premier plan (11), ou avoisinant celui-ci, afin de générer un arrangement de sources lumineuses secondaires,
- comprenant une optique de transfert (17, 19, 20) pour le transfert superposant de la lumière d'éclairage (8) des sources lumineuses secondaires dans le champ d'éclairage (3),
- comprenant un dispositif de distribution de lumière (9, 10) pour la génération d'une distribution d'intensité bidimensionnelle prédéterminée à partie de la lumière d'éclairage (8) dans le premier plan (11) perpendiculairement par rapport à un axe optique (2) du système d'éclairage (5),

- un dispositif (14 ; 55 ; 70 ; 79 ; 88 ; 92 ; 106) supplémentaire actif optiquement est adjoint au voisinage au premier arrangement de trame (12 ; 102), ou est disposé dans un plan qui est conjugué optiquement à un plan dans lequel le premier arrangement de trame (12 ; 102) est disposé,

où le dispositif (14 ; 55 ; 70 ; 79 ; 88 ; 92 ; 106) supplémentaire actif optiquement influence une propriété de la lumière d'éclairage (8) faisant partie du groupe suivant :

-- l'intensité,
-- la phase,
-- la direction du rayonnement,
**caractérisé par**

- un dispositif de variation d'angle d'éclairage (14 ; 40 ; 47) disposé sur le trajet de la lumière au voisinage du premier arrangement de trame (12), ou dans un plan qui est optiquement conjugué à un plan dans lequel le premier arrangement de trame (12) est disposé, en tant que dispositif supplémentaire optiquement actif,

-- qui dévie la lumière d'éclairage (8), qui tombe sur le dispositif de variation d'angle d'éclairage (14 ; 40 ; 47) dans au moins deux portions de variation d'angle (30-33 ; 42, 43 ; 50, 51), perpendiculairement par rapport à l'axe optique (2) avec des angles de déviations différents ($\alpha$', $\gamma$'),
-- où un angle de déviation ($\alpha$', $\gamma$') maximal généré par le dispositif de variation d'angle d'éclairage (14 ; 40 ; 47) est si élevé qu'une contribution à l'intensité (36-38 ; 44, 45 ; 54) d'éléments de trame (23) du premier arrangement de trame (12) à l'intensité d'éclairage totale (39 ; 46 ; 54) varie dans le champ d'éclairage (3).

2. Système d'éclairage selon la revendication 1 **caractérisé par** un deuxième arrangement de trame (16), disposé dans le trajet de la lumière d'éclairage après le premier arrangement de trame (12), comportant les deuxièmes éléments de trame (28), qui forme, ensemble avec le premier arrangement (12), un module de trame (13).

3. Système d'éclairage selon l'une des revendications 1 à 2 **caractérisé par** une configuration du dispositif supplémentaire optiquement actif (14) de telle manière que, dans la zone du premier arrangement de trame (12), une influence de la propriété de la lumière d'éclairage (8) soit instaurée, qui est transformée par l'optique de transfert (17) en une distribution d'intensités totale (39) dépendant du champ d'éclairage, différents points du champ d'éclairage étant éclairés par des contributions d'intensité différentes (34, 36-38) parmi les directions d'éclairage (I-IV) possibles.

4. Système d'éclairage selon l'une des revendications 1 à 2 **caractérisé par** une configuration du dispositif supplémentaire optiquement actif (47) de telle manière que, dans la zone du premier arrangement de trame (12), une influence de la propriété de la lumière d'éclairage (8) soit instaurée, qui est transformée par l'optique de transfert (17) en une distribution d'intensités totale dépendant du champ d'éclairage (54), différents points du champ d'éclairage étant éclairés par des contributions d'intensité identiques (54) parmi les directions d'éclairage (I-IV) possibles.

5. Système d'éclairage selon l'une des revendications 1 à 2 **caractérisé par** une configuration du dispositif supplémentaire optiquement actif (40) de telle manière que, dans la zone du premier arrangement de trame (12), une influence de la propriété de la lumière d'éclairage (8) soit instaurée, qui est transformée par l'optique de transfert (17) en une distribution d'intensités totale (46) indépendante du champ d'éclairage, différents points du champ d'éclairage étant éclairés par des contributions d'intensité différentes (44, 45) parmi les directions d'éclairage (I-IV) possibles.

6. Système d'éclairage selon l'une des revendications de 1 à 5 **caractérisé par** une subdivision des dispositifs de variation d'angles d'éclairage (14 ; 40 ; 47) dans au moins deux portions de variation d'angles (30, 33 ; 42, 43 ; 50, 51) dans lesquelles l'angle de déviation ($\alpha$', $\gamma$') généré est différent.

7. Système d'éclairage selon la revendication 6 **caractérisé par** une subdivision du dispositif de variation d'angles d'éclairage (14) dans au moins quatre portions de variation d'angles (30-33) dans lesquelles l'angle de déviation ($\alpha$', $\gamma$') généré est différent chaque fois.

8. Système d'éclairage selon l'une des revendications de 1 à 7 **caractérisé en ce que** le dispositif supplémentaire optiquement actif (40 ; 47) est conçu diffractif.

9. Système d'éclairage selon l'une des revendications de 1 à 7 **caractérisé en ce que** le dispositif supplémentaire optiquement actif (14 ; 40 ; 47) est conçu réfractif.

10. Système d'éclairage selon l'une des revendications de 1 à 9 **caractérisé en ce que** le dispositif de variation d'angle d'éclairage (40 ; 47) présente au moins un prisme en toit (40 ; 48).

11. Equipement d'éclairage par projection de micro lithographie (1) comprenant un système d'éclairage (5) selon l'une des revendications de 1 à 10.

12. Procédé d'élaboration par micro lithographie de composants micro structurés comprenant les étapes suivantes :

- préparation d'un substrat sur lequel est rapportée au moins partiellement une couche de matériau sensible à la lumière,
- préparation d'un réticule qui présente des structures à représenter,
- préparation d'un équipement d'éclairage par projection (1) selon la revendication 11,
- projection d'au moins une partie du réticule sur une zone de la couche à l'aide de l'équipement d'éclairage par projection (1).

Fig. 1

EP 1 984 789 B1

Fig. 2

Fig. 3

Fig. 4

Fig. 5

EP 1 984 789 B1

44   45

I ( - ) —— 34
II ( - ) —— 36
III ( + ) —— 37
IV ( + ) —— 38

I ( + ) —— 34
II ( + ) —— 36
III ( - ) —— 37
IV ( - ) —— 38

I

Fig. 6

Fig. 7

Fig. 8

EP 1 984 789 B1

Fig. 9

Fig. 10

EP 1 984 789 B1

Fig. 11

Fig.12

71   70   23,28

72

Fig. 13

-x
18

35

x=0

$I_1$ $I_0$

Fig. 14

73   23,28

78
77
74
76
75

Fig. 15

EP 1 984 789 B1

Fig. 16

Fig. 17

Fig. 18

Fig. 19

EP 1 984 789 B1

Fig. 20

EP 1 984 789 B1

Fig. 21

Fig. 22

Fig. 23

Fig. 24

EP 1 984 789 B1

Fig. 25

Fig. 26

EP 1 984 789 B1

Fig. 27

EP 1 984 789 B1

Fig. 28

EP 1 984 789 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1367442 A2
- WO 03029875 A2
- US 20020136351 A1
- WO 2005083512 A2
- US 20040119961 A1
- WO 2006084478 A1